# EUROPÄISCHE PATENTSCHRIFT

(11) **EP 3 649 838 B1**
(45) Veröffentlichungstag und Bekanntmachung des Hinweises auf die Patenterteilung: **10.01.2024**
(21) Anmeldenummer: 18737256.0
(22) Anmeldetag: 04.07.2018
(51) Int. Cl.: H05K 7/20, H01L 23/40

(54) **STEUERUNG UND MODULARES STEUERUNGSSYSTEM EINES INDUSTRIELLEN AUTOMATISIERUNGSSYSTEMS**
CONTROL UNIT AND MODULAR CONTROL SYSTEM OF AN INDUSTRIAL AUTOMATION SYSTEM
COMMANDE ET SYSTÈME DE COMMANDE MODULAIRE D'UN SYSTÈME D'AUTOMATISATION INDUSTRIEL

(30) Priorität: 04.07.2017 DE 202017103994 U
(43) Veröffentlichungstag der Anmeldung: 13.05.2020
(73) Patentinhaber: Weidmüller Interface GmbH & Co. KG, 32758 Detmold (DE)
(72) Erfinder: GURLT, Ingo, 33602 Bielefeld (DE); KLUG, Tobias, 32107 Bad Salzuflen (DE); SCHNATWINKEL, Michael, 32051 Herford (DE); SCHUMACHER, Ralf, 32657 Lemgo (DE); KRONER, Michael, 33813 Oerlinghausen (DE); PÜSCHNER, Klaus, 32760 Detmold (DE); STRÜNKMANN, Marc, 33104 Paderborn (DE)
(74) Vertreter: Kleine, Hubertus
(86) Internationale Anmeldenummer: PCT/EP2018/068084
(87) Internationale Veröffentlichungsnummer: WO 2019/008032

(56) Entgegenhaltungen:
- EP-A1- 1 552 983
- EP-A1- 3 032 366
- WO-A2-2009/120942
- DE-A1-102006 046 194
- DE-A1-102015 104 290
- DE-A1-102015 111 204
- DE-B3-102012 103 217
- US-A- 5 598 322

## Beschreibung

Die Erfindung betrifft eine Steuerung für ein industrielles Automatisierungssystems, aufweisend ein Hauptmodul mit einem Gehäuse, das mit einem Sockel auf eine Hutschiene aufsetzbar ist, und mit mindestens zwei in dem Gehäuse angeordneten Leiterplatten, von denen eine eine Rückwandbusleiterplatte und eine eine Hauptleiterplatte ist, wobei der Hauptleiterplatte ein Kühlkörper zur Kühlung von Komponenten zugeordnet ist und wobei die Rückwandbusleiterplatte einen Rückwandbus für mindestens ein seitlich anreihbares Erweiterungsmodul bereitstellt. Die Erfindung betrifft weiterhin ein modulares Steuerungssystem mit einem derartigen Hauptmodul.

In industriellen Automatisierungssystemen werden Steuerungen, auch SPS (Speicher Programmierbare Steuerung), PLC (Programmable Logic Controller) oder PAC (Programmable Automation Controller) genannt, eingesetzt, um Aktoren anzusteuern und Messdaten über Sensoren einzulesen. In der Regel erfolgt die Ansteuerung der Aktoren bzw. das Auslesen der Sensoren über Feldgeräte, die über ein oder mehreren Feldbussen mit der Steuerung verbunden sind. Zu den Feldgeräten gehören u.a. Ein- und Ausgangsmodule, auch I/O (Input/Output) - Module genannt, die analoge und/oder digitale Ein- oder Ausgangskanäle bereitstellen. Häufig wird dabei nicht jedes einzelne Feldgerät unmittelbar an den Feldbus angeschlossen, sondern über einen sogenannten Feldbuskoppler, der eine Schnittstelle zwischen dem Feldbus einerseits und einem Subbus, über den eine Mehrzahl von Feldgeräten anschließbar ist, dargestellt. Sensoren und Aktoren können auch jeweils mit einem eigenen Feldbusanschluss zur Verbindung mit dem Feldbus versehen sein.

Alternativ oder zusätzlich zur Übertragung über dem Feldbus kann vorgesehen sein, Feldgeräte auch unmittelbar in vergleichbarer Weise wie bei einem Feldbuskoppler an die Steuerung anzuschließen, indem diese einen Subbus, der mit dem eines Feldbuskopplers vergleichbar ist, bereitstellt.

In der Regel ist vorgesehen, Steuerungen in einem der Industrieanlage zugeordneten Schaltschrank anzuordnen. Zu diesem Zweck weisen Steuerungen typische Montagelemente wie beispielsweise eine Hutschienenaufnahme auf. Die Anordnung in einem Schaltschrank setzt Randbedingungen für die geometrische, mechanische, thermische und elektrische Auslegung der Steuerung. Der für Komponenten der Steuerung und insbesondere für Anschlüsse der Steuerung verfügbare Platz ist stark eingeschränkt. Die thermische Belastung kann zudem hoch sein, sodass bei kompakter Bauweise eine gute Kühlung der Komponenten erzielbar sein muss. Zudem ändern sich Anforderungen an Leistungsfähigkeit und/oder die verfügbaren Schnittstellen der Steuerung häufig im Laufe der Zeit, sodass eine flexible Erweiterbarkeit der Steuerung wünschenswert ist.

Aus der Druckschrift DE 10 2014 118 389 A1 ist ein erweiterbares Automatisierungsgerät, das als Steuerung ausgebildet sein kann, bekannt, bei dem ein Hauptmodul, das die Hauptfunktionalität bereitstellt, um ein oder mehrere Anschlussmodule erweiterbar ist, um das Hauptmodul mit verschiedenen Feldbussystem betreiben zu können. Nachteilig dabei ist, dass in jedem Fall eine Kombination aus Hauptmodul und Anschlussmodul eingesetzt werden muss, um eine funktionsfähige Steuerung aufzubauen.

Die Druckschrift DE 10 2012 103217 B3 offenbart ein an einer Hutschiene montierbares Modul mit einem Gehäuse, einer ersten Leiterplatte, einer zweiten Leiterplatte und einem auf der ersten Platte angeordneten Kühlkörper.

Die Druckschrift WO 2009/120942 A2 offenbart ein modulares Bussystem, wobei jedes Modul eine Busplatine zur Verbindung mit benachbarten Modulen und eine Hauptplatine zur Steuerung eines Ventils umfasst.

Die Druckschrift DE 10 2006 046194 A1 offenbart einen Kühlkörper zur Kühlung eines darauf befestigten elektrischen Bauelements.

Es ist eine Aufgabe der vorliegenden Erfindung, eine Steuerung und ein modulares Steuerungssystem bereitzustellen, die bei kompaktem Aufbau eine gute Kühlung elektronischer Komponenten ermöglicht, die flexibel in Hinblick auf zur Verfügung stehende Leiterplattenfläche und Anschlussmöglichkeiten sind und einen kompakten Aufbau aufweisen.

Diese Aufgabe wird durch eine Steuerung und ein Steuerungssystem mit den Merkmalen des jeweiligen unabhängigen Anspruchs gelöst.

Eine erfindungsgemäße Steuerung für ein industrielles Automatisierungssystem der eingangs genannten Art zeichnet sich dadurch aus, dass der Kühlkörper in dem Gehäuse angeordnet ist, an dem Sockel befestigt ist und mindestens eine der Leiterplatten trägt. Der Kühlkörper wird so als ein zentrales Element der Steuerung eingesetzt, das zumindest eine, bevorzugt auch mehrere der Leiterplatten des Hauptmoduls trägt, d.h. das diese Leiterplatten an dem Kühlkörper befestigt sind. Auf diese Weise wird der zur Verfügung stehende Platz im Gehäuse optimal genutzt, so dass ein kompaktes Hauptmodul mit einer hohen Bauteiledichte realisiert werden kann. Zudem wird der Zusammenbau des Hauptmoduls vereinfacht, da eine zentrale Baugruppe mit Leiterplatten, die an dem Kühlkörper befestigt sind, vormontiert werden kann, die dann als Ganzes in den Sockel eingesetzt und mit diesem verbunden wird.

In einer vorteilhaften Ausgestaltung der Steuerung weist der Kühlkörper einen im wesentlich quaderförmigen Umriss auf und steht mit zwei zueinander senkrechten Außenflächen parallel zu der Hauptleiterplatte und der Rückwandbusleiterplatte steht. Auf diese Weise können eine im Sockel liegende Rückwandbusleiterplatte und eine dazu senkrecht stehende Hauptleiterplatte kompakt über den Kühlkörper miteinander verbunden werden. Bevorzugt sind sowohl die Hauptleiterplatte als auch die Rückwandbusleiterplatte an dem Kühlkörper befestigt.

Weiter bevorzugt ist zumindest eine Außenfläche des Kühlkörpers als Kühlfläche ausgebildet, mit der die Komponenten der Hauptleiterplatte in thermischem Kontakt stehen. Die Kühlfläche kann dabei gestuft ausgebildet sein und Plateaus in verschiedenen Höhen aufweisen, um unterschiedlich hohe Bauelemente der Hauptleiterplatte gleichermaßen gut zu kontaktieren.

In einer weiteren vorteilhaften Ausgestaltung der Steuerung weist der Kühlkörper mindestens einen Montagefuß auf, der bis in den Sockel hineinragt und dort befestigt ist. So kann das im Sockel zur Verfügung stehende Volumen zur Befestigung des Kühlkörpers genutzt werden und es verbleibt möglichst viel nutzbares Volumen in dem oberhalb des Sockels liegend Bereich für Leiterplatten. Zudem kann auch die senkrecht stehende Hauptleiterplatte parallel zur Kühlfläche des Kühlkörpers bis in den Sockel hineingeführt sein. Auf diese Weise wird zusätzlicher Bestückungsraum auf der Hauptleiterplatte geschaffen, ohne die Bauhöhe des Hauptmoduls, d. h. die Höhe über der Hutschiene, zu vergrößern.

Um eine schnelle und unkomplizierte Montage des Hauptmoduls zu ermöglichen, wird eine Kühlkörper und Leiterplatten umfassende Baugruppe nur mit dem mindestens einen Montagefuß an dem Sockel befestigt.

In einer weiteren vorteilhaften Ausgestaltung der Steuerung weist der Kühlkörper innere Kühlfinnen auf, durch die Kühlkanäle ausgebildet sind. So weist der Kühlkörper große Außenflächen auf, die als Kühlflächen eingesetzt werden können und in thermischen Kontakt mit zu kühlenden Komponenten stehen, und es wird eine hohe Kühlleistung des Kühlkörpers erzielt. Bevorzugt verlaufen die inneren Kühlfinnen senkrecht zu der Hauptleiterplatte, um von dort eingetragene Wärme bestmöglich abzuleiten.

In einer weiteren vorteilhaften Ausgestaltung der Steuerung weist der Kühlkörper äußere Kühlfinnen auf, neben denen mindestens eine Zusatzleiterplatte angeordnet ist. Mit den Zusatzleiterplatten kann der Zwischenraum zwischen den äußeren Kühlfinnen optimal genutzt werden, um weiteren Bauraum für Komponenten zu schaffen. Die äußeren Kühlfinnen verlaufen bevorzugt parallel zu der Hauptleiterplatte. Bevorzugt ist zumindest eine der äußeren Kühlfinnen in einer Längsrichtung kürzer als andere Abschnitte des Kühlkörpers, wodurch Platz für elektrische Verbindungen zwischen der Hauptleiterplatte und der oder den Zusatzleiterplatte(n) zu schaffen.

Ein erfindungsgemäßes Steuerungssystem umfasst eine Steuerung der zuvor beschriebenen Art mit einem Hauptmodul und ist um mindestens ein angereihtes Ergänzungsmodul erweitert, wobei das Hauptmodul über eine Rückwandbusleiterplatte mit dem mindestens einem Erweiterungsmodul verbunden ist. Es ergeben sich die im Zusammenhang mit der Steuerung beschriebenen Vorteile in einem zudem flexibel erweiterbaren System.

Die erfindungsgemäße Steuerung und das erfindungsgemäße Steuerungssystem werden nachfolgend anhand von Ausführungsbeispielen mit Hilfe von Figu-ren näher erläutert. Die Figuren zeigen:
- Fig.1: eine schematische isometrische Ansicht eines Steuerungssystems;
- Fig. 2 - 2c: verschiedene Ansichten eines weiteren Ausführungsbeispiels eines Steuerungssystems;
- Fig. 3a, 3b: zwei verschieden isometrische Ansichten eines Ausführungsbeispiels eines Hauptmoduls einer Steuerung;
- Fig. 4a - 4c: verschiedene Ansichten des Hauptmoduls gemäß Fig. 3a, b mit aufgesetztem Gehäusedeckel;
- Fig. 5a - 5d: verschiedene Ansichten eines weiteren Ausführungsbeispiels eines Hauptmoduls einer Steuerung, dargestellt ohne Gehäusedeckel und teilweise ohne Sockel;
- Fig. 6a - 6c: das Hauptmodul der Fig. 5a bis 5d mit aufgesetztem Gehäusedeckel;
- Fig. 7a - 7e: verschiedene Ansichten eines weiteren Ausführungsbeispiels eines Hauptmoduls einer Steuerung, dargestellt ohne Gehäusedeckel und ohne Sockel;
- Fig. 8a, 8b: das Hauptmodul der Fig. 7a bis 7e mit Sockel bzw. Sockel und aufgesetztem Gehäusedeckel;
- Fig. 9: eine isometrische Ansicht eines weiteren Ausführungsbeispiels eines Hauptmoduls einer Steuerung, dargestellt ohne Gehäusedeckel und ohne Sockel;
- Fig. 10a, 10b: zwei verschiedene isometrische Ansichten eines ersten Ausführungsbeispiels eines Erweiterungsmoduls für ein Steuerungssystem;
- Fig. 11a, 11b: zwei verschiedene isometrische Ansichten eines zweiten Ausführungsbeispiels eines Erweiterungsmoduls für ein Steuerungssystem; und
- Fig. 12a - 12c: schematische Draufsichten auf ein Hauptmodul einer Steuerung in verschiedenen Anschlusskonfigurationen.

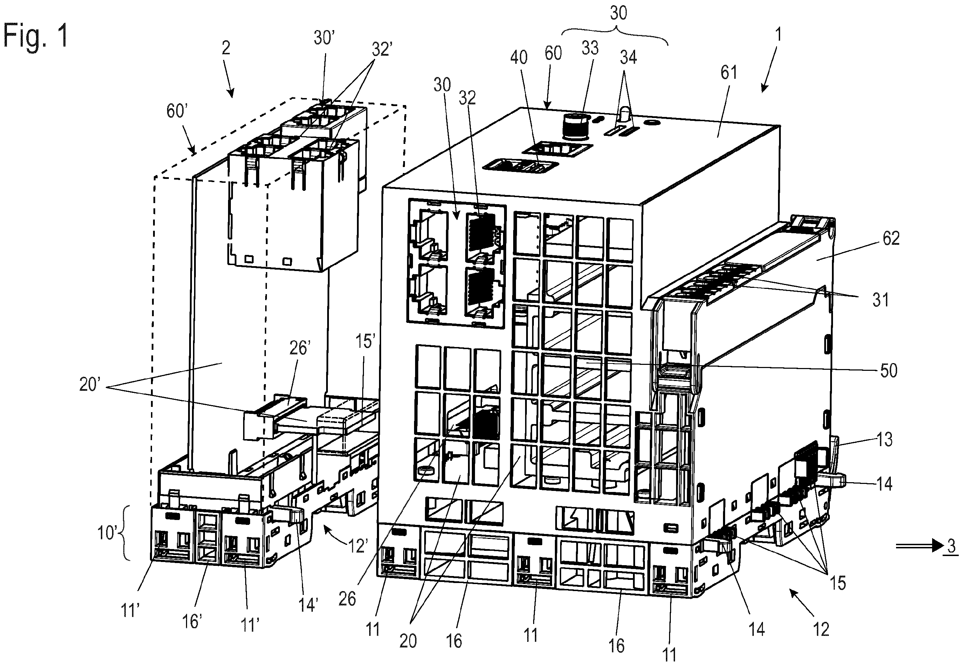

Fig. 1 zeigt in einer schematischen isometrischen Ansicht ein erstes Ausführungsbeispiel eines Steuerungssystems. Das Steuerungssystem umfasst ein Hauptmodul 1 sowie in diesem Beispiel ein Erweiterungsmodul 2.

Im Rahmen dieser Anmeldung kennzeichnen gleiche Bezugszeichen in allen Figuren gleiche oder gleichwirkende Elemente. Bei dem Erweiterungsmodul 2 sind zur besseren Unterscheidbarkeit Bezugszeichen der Komponenten mit einem Apostroph versehen.

Das Steuerungssystem der Fig. 1 ist zur Montage in einem Schaltschrank vorgesehen. Die übliche Montageorientierung ist derart, dass die in der Fig. 1 untere, nicht sichtbare, Seite vertikal im Schaltschrank festgelegt ist. Diese Seite wird nachfolgend auch als Montageseite bezeichnet. Die in der Fig. 1 oben liegende Seite ist somit parallel zur "Montageseite" ausgerichtet und verläuft ebenfalls bei einer Schaltschrankmontage senkrecht. Sie weist auf den Bediener oder Benutzer zu und wird nachfolgend als "Frontseite" bezeichnet. Die in der Fig. 1 sichtbare, dem Betrachter zugewandte Seite ist bei einer typischen Schaltschrankmontage horizontal ausgerichtet und wird nachfolgend als "Unterseite" bezeichnet. Die in der Fig. 1 nicht sichtbare, dem Betrachter abgewandte Seite, die bei der Schaltschrankmontage ebenfalls horizontal ausgerichtet wird als "Oberseite" bezeichnet.

An die in der Fig. 1 linke Seite des Hauptmoduls 1 schließt sich das Erweiterungsmodul 2 an, das der besseren Darstellung halber in der Fig. 1 getrennt vom Hauptmodul 1 wiedergegeben ist. Diese linke Seite des Hauptmoduls 1 bzw. des Erweitungsmoduls 2 ist auch bei einer Montage im Schaltschrank die linke Seite und wird nachfolgend als solche bezeichnet. An die rechte Seite des Hauptmoduls 1, die auch bei Schaltschrankmontage die rechte Seite des Hauptmoduls 1 ist und als solche nachfolgend bezeichnet wird, können sich hier nicht dargestellte Ein- / Ausgabemodule 3 anschließen.

Das Hauptmodul 1 weist einen Sockel 10 auf, auf den ein Gehäusedeckel 60 aufgesetzt ist. Der Sockel 10 ist wie in diesem Ausführungsbeispiel dargestellt bevorzugt aus mehreren Komponenten aufgebaut, vorliegend aus drei parallel zueinander ausgerichteten Rastträgern 11, die durch Abstandselemente 16 voneinander beabstandet sind. Die Rastträger 11 dienen der Befestigung des Hauptmoduls 1 an einer Hutschiene des Schaltschranks, auf die sie aufgerastet werden können.

An der Oberseite des Hauptmoduls 1 sind an jedem Rastträger 11 Entriegelungshebel 13 angeordnet, die bei Betätigung die Rastträger 11 entriegeln, so dass das Hauptmodul 1 von der Hutschiene abgenommen werden kann. Der auf der rechten Seite des Hauptmoduls 1 angeordnete Rastträger 11 weist abstehende Rasthaken 14 auf, mit denen die genannten Ein- / Ausgabemodule 3 an das Hauptmodul 1 angerastet werden können. Die Ein- / Ausgabemodule 3 sind Ihrerseits mit vergleichbaren Rastträgern 11 ausgestattet, so dass sie auf die Hutschiene aufgesetzt und durch Heranschieben an das Hauptmodul 1 angerastet werden können.

Der rechte Rastträger 11 des Hauptmoduls 1 trägt zudem verschiedene Buskontakte 15, über die eine Stromversorgung und auch Daten an die angesetzten Ein-/ Ausgabemodule 3 übertragen werden können. Die mechanische Ausgestaltung der rechten Seite des Hauptmoduls 1 sowie die elektrische und mechanische Ausgestaltung der Buskontakte 15 entspricht der eines systemgleichen Feldbuskopplers, so dass die für diesen systemgleichen Feldbuskoppler konstruierten Ein- / Ausgabemodule 3 sich hier unmittelbar an das Hauptmodul 1 des Steuerungssystems anschließen können. Diese ermöglicht eine direkte Verwendung der Ein- / Ausgabemodule 3 ohne einen zwischengeschalteten Feldbus und Feldbuskoppler.

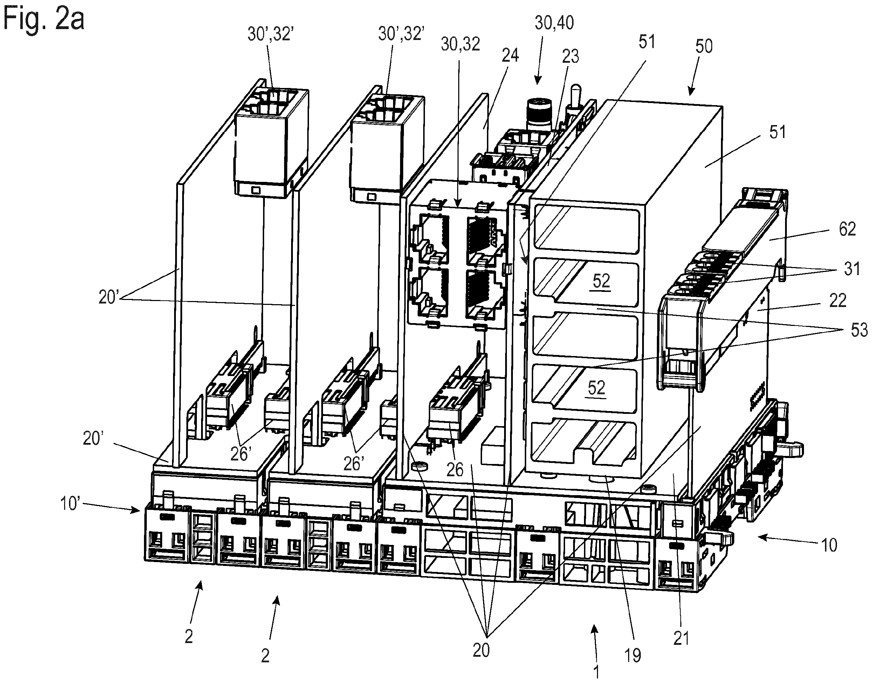

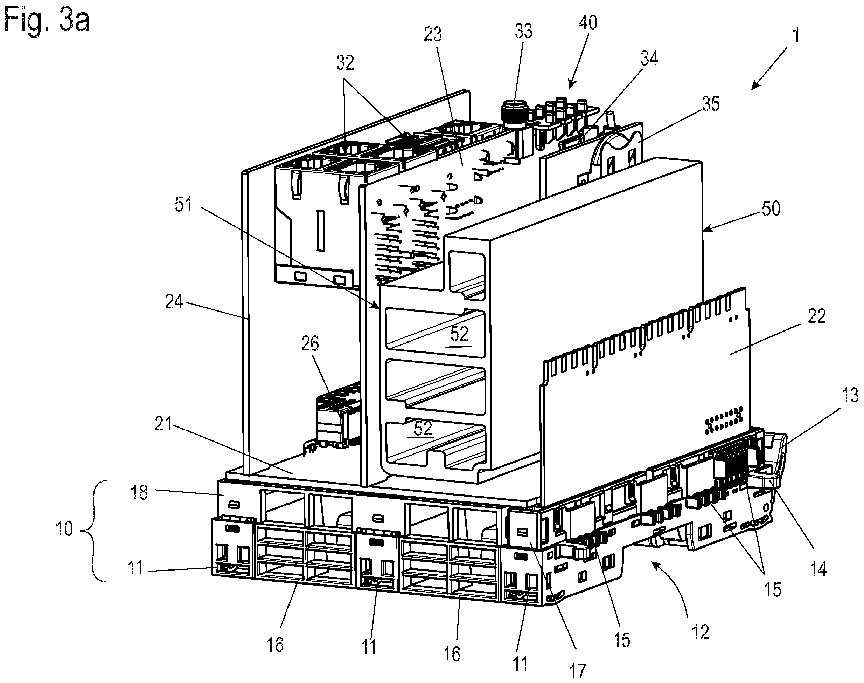

Im gleichen Formfaktor, den auch die Ein- / Ausgabemodule 3 haben, ist die rechte Seite des Hauptmoduls 1 ausgestaltet. Sie weist einen Abschnitt auf, in dem Stromversorgunganschlüsse 31 positioniert sind. Die Stromversorgungsanschlüsse 31 sind dabei als Einsteckelemente mit einem Leiterplattenendverbinder ausgebildet, die auf eine unterhalb angeordnete Leiterplatte (vgl. z.B. Fig. 2a oder 3a) aufgesteckt werden. Die Einsteckelemente können als Stromversorgunganschlüsse 31 verschiedene gewünschte Kontaktarten bereitstellen, beispielsweise Push-In-Kontakte, Schraubkontakte oder Steckverbinder. Um die Einsteckelemente der Stromversorgungsanschlüsse 31 austauschen zu können, ist der Gehäusedeckel 60 in diesem Bereich als eine hochklappbare Klappleiste 62 ausgebildet. Dieses System und dieser Formfaktor ist bevorzugt in vergleichbarer Art und Weise bei den ansetzbaren Ein- / Ausgabemodulen 3 umgesetzt.

In seinem breiteren linken Teil ist der Bauraum des Hauptmoduls 1 größer und entsprechend der Gehäusedeckel 60 durch einen die Klappleiste 62 in der Höhe ragenden Hauptdeckel 61 gebildet. An Unter- und Oberseite sind bevorzugt Lüftungsdurchbrüche 63 ausgebildet, durch die ein Konvektionsluftstrom von unten nach oben durch das Hauptmodul 1 führt. Bei extremeren thermischen Umgebungsbedingungen kann an der Unterseite oder der Oberseite auf den Hauptdeckel 61 ein Lüfter aufgesetzt werden, der einen erzwungenen Luftstrom durch das Hauptmodul 1 zur besseren Kühlung hervorruft. In raueren Umgebungsbedingungen können zudem Filterelemente vorgesehen sein, die ein Eindringen von Schmutz durch die Lüftungsdurchbrüche 63 minimieren.

Bei dem dargestellten Ausführungsbeispiel des Hauptmoduls 1 sind Anschlüsse 30 an der Unterseite vorgesehen, wohingegen die Frontseite des Hauptmoduls 1 Schalt- und Signalelemente 40, beispielsweise Statusanzeigen, Schalter oder Taster aufweist. Ebenfalls an der Frontseite ist ein Antennenanschluss 33 angeordnet. Zudem ist an der Frontseite ein Speicherkartenanschluss 34 mit einem Einsteckschacht für z.B. (micro)-SD-Speicherkarte angeordnet. Details zum inneren Aufbau des Hauptmoduls 1 werden in nachfolgenden Figuren erläutert.

Das Erweiterungsmodul 2, das an die linke Seite des Hauptmoduls 1 angesteckt werden kann, weist einen grundsätzlich vergleichbaren Aufbau auf. Auch das Erweiterungsmodul 2 umfasst einen Sockel 10', der Rastträger 11' aufweist, die durch Abstandselemente 16' voneinander beabstandet sind. Rasthaken 14' dienen rastenden Verbindung mit dem Hauptmodul 1.

In der Fig. 1 ist ein Gehäusedeckel 60' des Erweiterungsmoduls 2 nur durch gestrichelt eingezeichnete Umrisse angedeutet und ansonsten transparent dargestellt, so dass ein innerer Aufbau sichtbar ist. Im Erweiterungsmodul 2 ist eine Leiterplatte 20' senkrecht angeordnet, die an ihrem in der Fig. 1 oberen Ende Anschlüsse 30' trägt. Diese sind entsprechend von der Frontseite des Erweiterungsmoduls 2 her zugänglich. An der rechten Seite des Erweiterungsmoduls 2 sind Buskontakte 15' vorhanden, im dargestellten Ausführungsbeispiel in Form eines Leiterplattenrandverbinders. Über die Buskontakte 15' sind das Hauptmodul 1 und das Erweiterungsmodul 2 miteinander gekoppelt. Auch der Aufbau des Erweiterungsmoduls 2 wird in nachfolgenden Figuren noch detaillierter dargestellt.

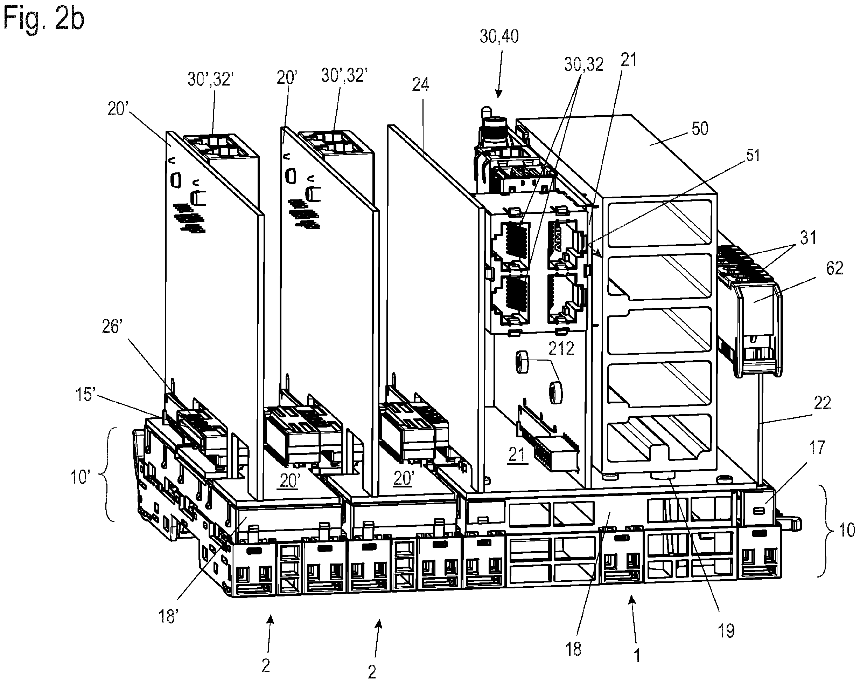

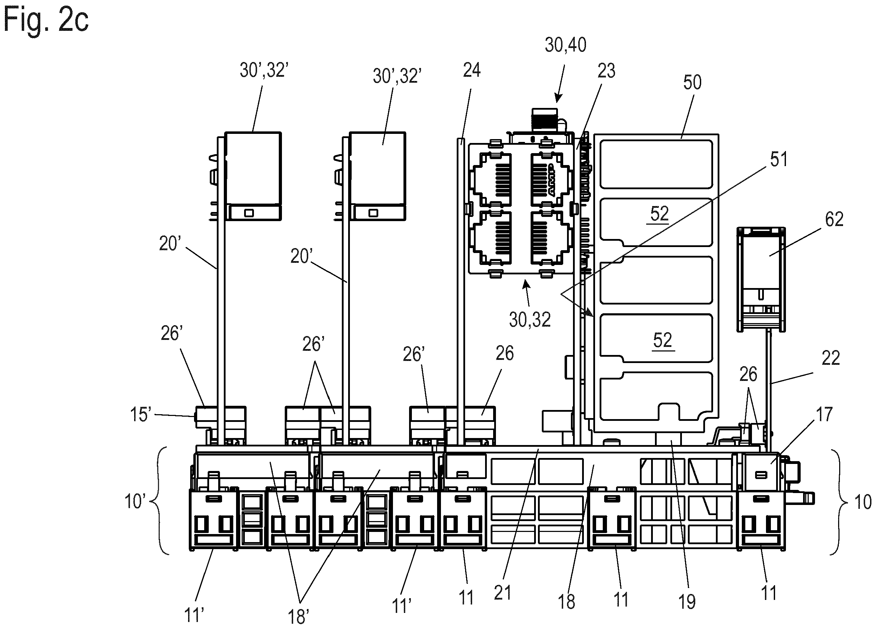

In den Fig. 2a bis 2c ist ein weiteres Ausführungsbeispiels eines Steuerungssystems in verschiedenen Ansichten dargestellt. Die Fig. 2a und 2b zeigen jeweils eine schematische isometrische Ansicht aus zwei verschiedenen Blickrichtungen und die Fig. 2c gibt eine Draufsicht auf die Frontseite des Steuerungssystems wieder. In den Fig. 2a bis 2c sind Gehäusedeckel 60, 60' entfernt, um Einblick in den inneren Aufbau des Steuerungssystems zu geben.

Bei dem in den Fig. 2a bis 2c dargestellten Steuerungssystem ist ein Hauptmodul 1 mit zwei Erweiterungsmodulen 2 verbunden. Beide Erweiterungsmodule 2 sind an der linken Seite des Hauptmoduls 1 hintereinander eingesteckt, ein erstes Erweiterungsmodul 2 ist also unmittelbar mit dem Hauptmodul 1 verbunden und ein zweites Erweiterungsmodul 2 in das erste Erweiterungsmodul 2 eingesteckt. Dieses ist möglich, da die Buskontakte 15' des Erweiterungsmoduls 2 durchgeschleift werden, so dass eine Aneinanderreihung mehrerer Erweiterungsmodule 2 erfolgen kann. Die linke Seite eines jeden Erweiterungsmoduls 2 ist zu diesem Zweck analog wie die linke Seite des Hauptmoduls 1 ausgebildet.

Vom Grundaufbau her sind das Hauptmodul 1 und die dargestellten Erweiterungsmodule 2 vergleichbar aufgebaut wie beim ersten Ausführungsbeispiel gemäß Fig. 1. Kleine Unterschiede betreffen die Ausgestaltung des Kühlkörpers 50, der beim Ausführungsbeispiel der Fig. 2a bis 2c die gesamte Bauhöhe des Hauptmoduls 1 einnimmt, wohingegen beim Ausführungsbeispiel der Fig. 1 ein Freiraum oberhalb des Kühlkörpers 50 verblieben ist, der ggf. anderweitig genutzt werden kann.

Ein weiterer Unterschied betrifft die Ausgestaltung der Buskontakte 15', die beim Ausführungsbeispiel der Fig. 2a bis 2c nicht als Leiterplattenrandverbinder ausgebildet sind. Stattdessen sind jeweils Steckverbinder 26 bzw. 26' vorgesehen, die ineinander gesteckt werden und die Buskontakte 15' aufweisen. Um die Aneinanderreihbarkeit mehrerer Erweiterungsmodule 2 zu ermöglichen, weisen die Erweitungsmodule der Fig. 2a bis 2c zudem eine parallel zur Montageseite bzw. Frontseite ausgerichtete Leiterplatte 20` auf, die die Steckverbinder für die Buskontakte 15' aufnimmt und die elektrisch über einen weiteren Steckverbinder mit senkrecht dazu ausgerichteten Haupt(-leiterplatten) 20' stehen.

Die Funktion der verschiedenen Leiterplatten 20 und 20' von Hauptmodul 1 und den Erweiterungsmodulen 2 werden nachfolgend auch noch detaillierter beschrieben.

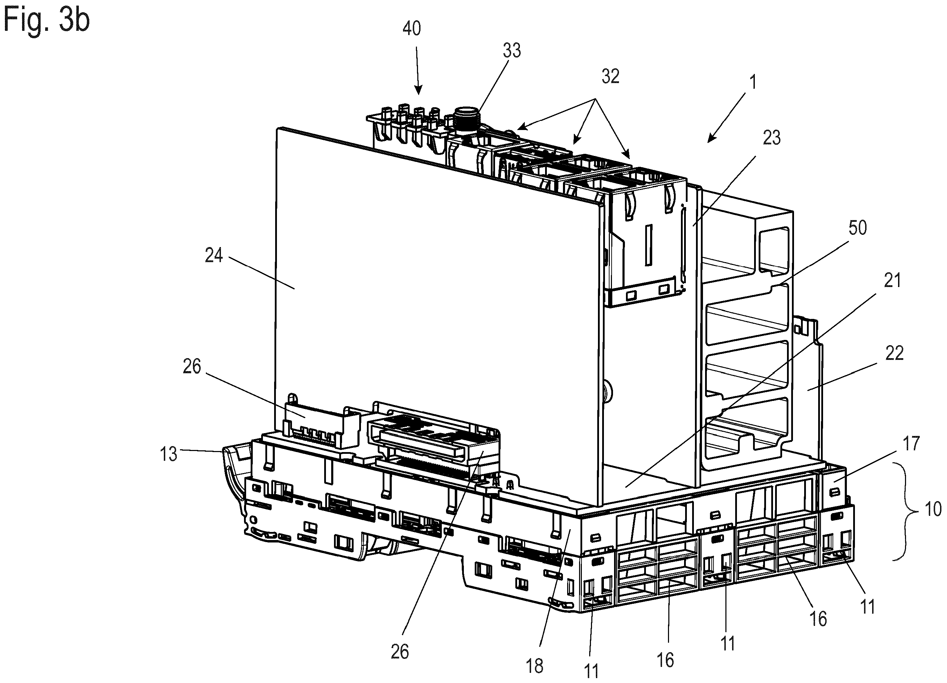

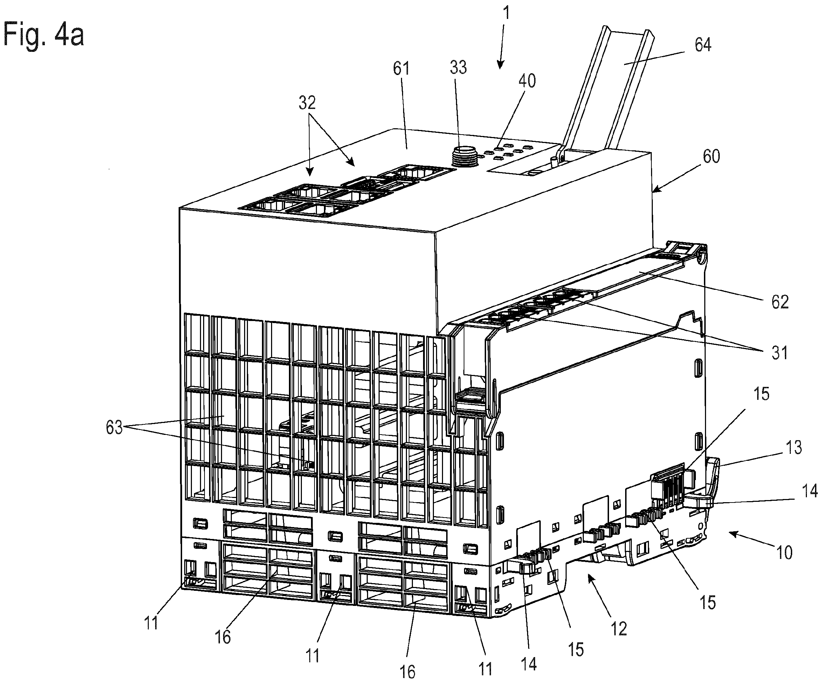

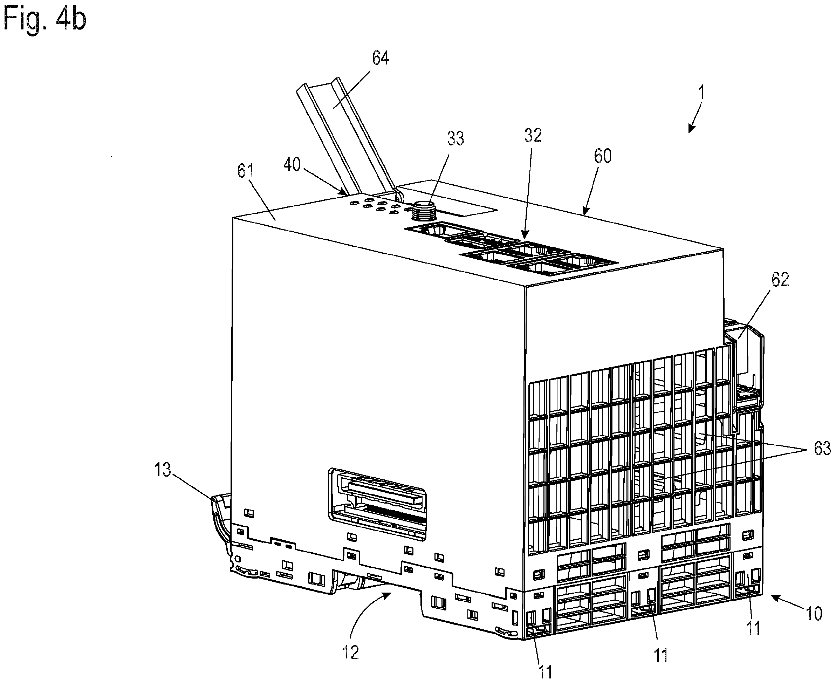

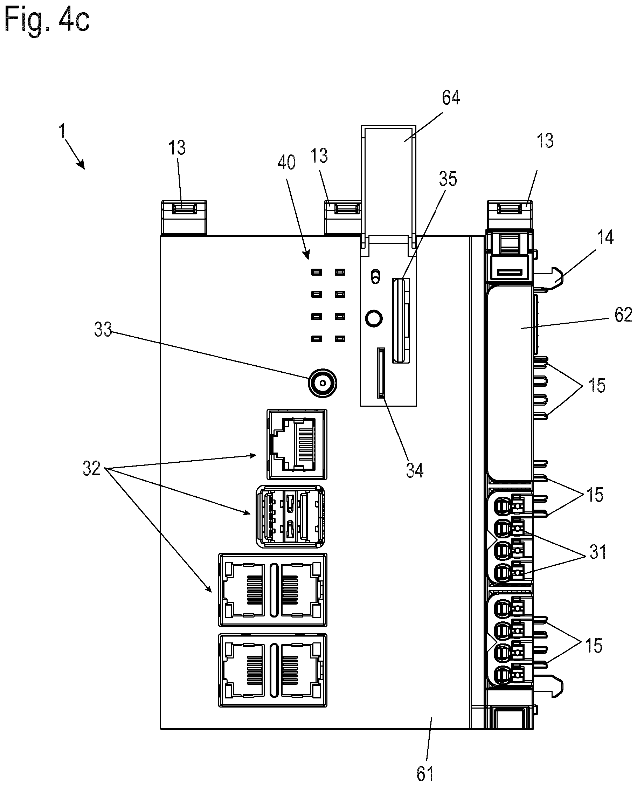

In den Fig. 3a, 3b und 4a - 4c ist ein Ausführungsbeispiel eines Hauptmoduls 1 einer Steuerung detaillierter dargestellt. Die Fig. 3a und 3b zeigen das Hauptmodul 1 ohne aufgesetzten Gehäusedeckel 60, um Einblick in den inneren Aufbau zu erhalten. Die Fig. 4a bis 4c zeigen verschiedene Ansichten des Hauptmoduls 1 mit aufgesetztem Gehäusedeckel 60. Die Fig 3a, 4b und 4a, 4b sind jeweils isometrische Ansichten aus verschiedenen Blickrichtungen und die Fig .4c eine Draufsicht auf die Frontseite des Hauptmoduls 1.

Die Ausgestaltung des Sockels 10 des Hauptmoduls 1 entsprich der der Hauptmodule 1 gemäß den Fig. 1 und 2a bis 2c. Auf die zugehörige Beschreibung wird hiermit verwiesen.

Das vorliegende Hauptmodul 1 weist eine Mehrzahl von Leiterplatten 20 auf, deren Anordnung und Funktion nachfolgend näher erläutert wird.

Auf dem Grundrahmen 18 des Sockels 10 ist zunächst eine Rückwandbusleiterplatte 21 angeordnet, die sich über die gesamte Fläche des Grundrahmens 18 erstreckt. Zur rechten Seite hin reicht die Rückwandbusleiterplatte 21 leicht über den Grundrahmen 18 bis auf den Leiterplattenträge 17 hinaus. Der Leiterplattenträger 17 trägt senkrecht eine Anschlussleiterplatte 22, die in den Leiterplattenträger 17 eingesteckt ist und bis zu den Buskontakten 15 an der rechten Seite des Hauptmoduls 1 reicht.

Die Buskontakte 15, über die Stromversorgung und Datenanbindung der Ein- / Ausgabemodule 13 erfolgt, werden entsprechend unmittelbar über die Anschlussleiterplatte 22 kontaktiert. Die Anschlussleiterplatte 22 steht senkrecht zur Rückwandbusleiterplatte 21 und ist mit dieser über einen winkeligen Steckverbinder 26 verbunden. Die Anschlussleiterplatte 22 weist an ihrem oberen Ende Leiterplattenrandverbinder auf, auf die die Stromversorgungsanschlüsse 31, die in der Klappleiste 62 angeordnet sind (vgl. Fig. 4a bis 4c) aufgesteckt sind.

Über diese Stromversorgungsanschlüsse 31 wird das Hauptmodul 1 mit Versorgungsspannung, in der Regel eine Gleichspannung im Bereich von 24V, versorgt. Auf der Anschlussleiterplatte 22 sind elektronische Komponenten zur Bereitstellung der Stromversorgung des Hauptmoduls 1 und der Ein- / Ausgabemodule 3 sowie angesteckter Erweiterungsmodule 2 angeordnet. Grundsätzlich sind im Rahmen dieser Anmeldung auf Leiterplatten 20 angeordnete Komponenten nur beispielhaft dargestellt. Es versteht sich, dass der in den Figuren nicht mit dargestellten Komponenten belegte Platz auf allen Leiterplatten 20 für elektrische bzw. elektronische Bauteile zur Verfügung steht. Alle Leiterplatten 20 können ein- oder (bevorzugt) beidseitig bestückt sein.

Die Rückwandbusleiterplatte 21 nimmt einen Rückwandbus für das Hauptmodul 1 und eventuelle Erweiterungsmodule 2 auf. Der Rückwandbus stellt Stromversorgungs- und Datenleitungen bereit. Die Datenleitungen bilden mindestens einen standardisierten und/oder proprietären Datenbus. Die Leitungen des Rückwandbusses werden z.B. über die Buskontakte 15' an ein eingestecktes Erweiterungsmodul 2 weitergereicht.

Auf der Rückwandbusleiterplatte 21 steht senkrecht etwa mittig im Hauptmodul 1 eine Hauptleiterplatte 23, die die wesentlichen Funktionselemente des Hauptmoduls 1 aufnimmt, insbesondere eine oder mehrere CPU (Central Processing Unit), ein oder mehrere FPGA (Field Programmable Gate Array), Speicherbausteine wie RAM (Random Access Memory), NVRAM (Non Volatile RAM) , eine RTC (Real Time Clock), sowie Schnittstellentreiber für Schnittstellenanschlüsse 32 und Schalt- und Signalelemente 40.

Diese Schnittstellenanschlüsse 32 und Schalt- und Signalelemente 40 sind im vorderen (in den Fig. oberen) Bereich der Hauptleiterplatte 23 angeordnet. Die Schalt- und Signalelemente 40 sowie der Antennenanschluss 33 können auf der Kante der Hauptleiterplatte 23 angeordnet sein, wohingegen die verschiedenen Schnittstellenanschlüsse 32 auf der der Anschlussleiterplatte 22 abgewandten Seite der Hauptleiterplatte 23 positioniert sind. Insbesondere sind als Schnittstellenanschlüsse 32 RJ-45 Anschlüsse vorgesehen oder D-SUB-Anschlüsse, die ebenfalls als Feldbusanschlüsse eingesetzt werden. Weiter können Schnittstellenanschlüsse 32 als SFP (Small Formfactor Plugable) Netzwerkanschlüsse, als USB-Anschlüsse, als Display-Anschlüsse oder auch als BL/SL-Anschlüsse ausgebildet sein. Der Antennenanschluss 33 kann beispielsweise SMA-Hochfrequenzanschluss ausgebildet sein.

Zwischen der Anschlussleiterplatte 22 und der Hauptleiterplatte 23 ist ein Kühlkörper 50 positioniert. Eine zur Hauptleiterplatte 23 weisende Kühlfläche 51 steht in thermischen Kontakt mit wärmeerzeugenden Bauteilen der Hauptleiterplatte 23, die bevorzugt auf der dem Kühlkörper 50 zugewandten Platinenseite angeordnet sind. Alle wärmeerzeugenden Bauteile wie die CPU, die FPGAs usw. können so über den Kühlkörper 50 gekühlt werden.

Der Kühlkörper 50 ist im dargestellten Beispiel auf Montagedomen 19 befestigt, die im Sockel 10 ausgebildet sind. Die Montagedome 19 können durch einen Durchbruch in der Rückwandbusleiterplatte 21 geführt sein, so dass der Kühlkörper unmittelbar mit dem Sockel 10 verbunden ist. Alternativ können die Montagedome 19 unterhalb der Rückwandbusleiterplatte 21 enden und es kann eine Schraube durch die Rückwandbusleiterplatte 21 und ein Distanzstück bis in den Kühlkörper 50 führen, so dass der Kühlkörper 50 zusammen mit der Rückwandbusleiterplatte 21 am Sockel 10 befestigt ist.

Bei dem dargestellten Ausführungsbeispiel ist der in den Figuren obere, der Frontseite zugewandte Kühlkanal 52 nicht über die gesamte Breite des Kühlkörpers 50 ausgebildet, so dass an der Rückseite der Hauptleiterplatte 23 ein Freiraum geschaffen ist, in dem eine kleine parallel zu Hauptleiterplatte 23 ausgerichtete Zusatzleiterplatte 25 positioniert ist. Diese kann über Lötstifte und/oder Steckverbinder mit der Hauptleiterplatte 23 verbunden sein und kann zusätzliche Schalt- und Signalelemente 40 oder auch Anschlüsse 30 aufnehmen.

Beim dargestellten Beispiel stellt die Zusatzleiterplatte 25 einen Speicherkartenanschluss 34 zur Aufnahme einer Micro-SD Speicherkarte bereit sowie einen Batterieanschluss 3 zur Aufnahme und Kontaktierung einer Pufferbatterie zur Versorgung z. B. der Echtzeituhr (RTC). Wie in den Fig. 4a bis 4c sichtbar ist, kann der Bereich, in dem der Speicherkartenanschluss 34 und auch die Batterie angeordnet ist durch eine Zugangsklappe 64 abgedeckt sein, um eine eingesetzte Speicherkarte bzw. Batterie vor versehentlicher Entnahme zu schützen. Im Hauptdeckel 61 kann auch ein Display angeordnet sein, bzw. ein Durchbruch, durch den ein Display zugänglich ist. Das Display kann mit einer Touch-Funktion ausgestattet sein und ein Schalt- und Signalelement 40 bilden.

Die in diesem Ausführungsbeispiel in der Frontseite positionierten Schnittstellenanschlüsse 32 können in alternativen Ausgestaltungen auch von der Unterseite des Hauptmoduls 1 her zugänglich sein, wie dieses beim Ausführungsbeispiel der Fig. 1 und 2a bis 2c umgesetzt ist.

An der linken Seite des Hauptmoduls 1 ist parallel zur Hauptleiterplatte 23 eine optionale Ergänzungsleiterplatte 24 angeordnet. Diese Ergänzungsleiterplatte 24 kann beispielsweise ebenfalls Schnittstellentreiber und weitere Schnittstellenanschlüsse 32 aufweisen, die dann an der Front oder Unterseite des Hauptmoduls 1 zugänglich sind. Es kann auf diese Weise eine größere Variante an Schnittstellen bereit gestellt werden. Die einzelnen Schnittstellenanschlüsse 32 sind auf der Hauptleiterplatte 23 und der Ergänzungsleiterplatte 24 so positioniert, dass sie ohne sich zu stören den zwischen diesen Leiterplatten liegenden Bauraum ausnutzen.

Die Ergänzungsleiterplatte 24 kann zudem verwendet werden, um besonders schnelle Ein- / Ausgabekanäle über FPGA- oder GPIO (General Purpose Input Output)- Bausteine mit ggf. direktem Zugriff auf den Rückwandbus bereit zu stellen. Auf diese Weise können spezielle Ein- / Ausgabekanäle mit Schaltzeiten im Bereich vom Nanosekunden realisiert werden.

In einer Aussparung der Erweiterungsleiterplatte 25 ist auf der Rückwandbusleiterplatte 21 der Steckkontakt montiert, um Erweiterungsmodule 2 über die dessen Buskontakte 15' mit dem Hauptmodul 1 zu verbinden. Neben der Funktion der Weiterleitung und Verteilung des Rückwandbusses kann die Rückwandbusleiterplatte 21 alternativ auch verwendet werden, um Stützkondensatoren zur Glättung und Stützung der Stromversorgungsleitung des Rückwandbusses aufzunehmen. Auch ist denkbar, die Pufferbatterie der Echtzeituhr (RTC), die sich beim dargestellten Ausführungsbeispiel auf der Zusatzleiterplatte 25 befindet, auf der Rückwandbusleiterplatte 21 anzuordnen. Im Gehäusedeckel 60 ist dann an entsprechender Stelle eine Klappe oder Abdeckung vorgesehen, durch die die Pufferbatterie zugänglich ist und getauscht werden kann.

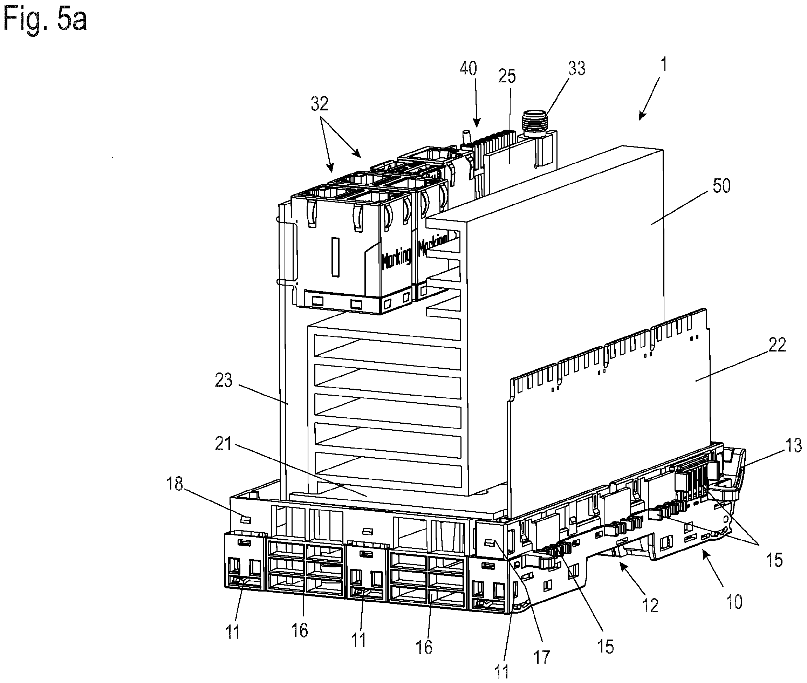

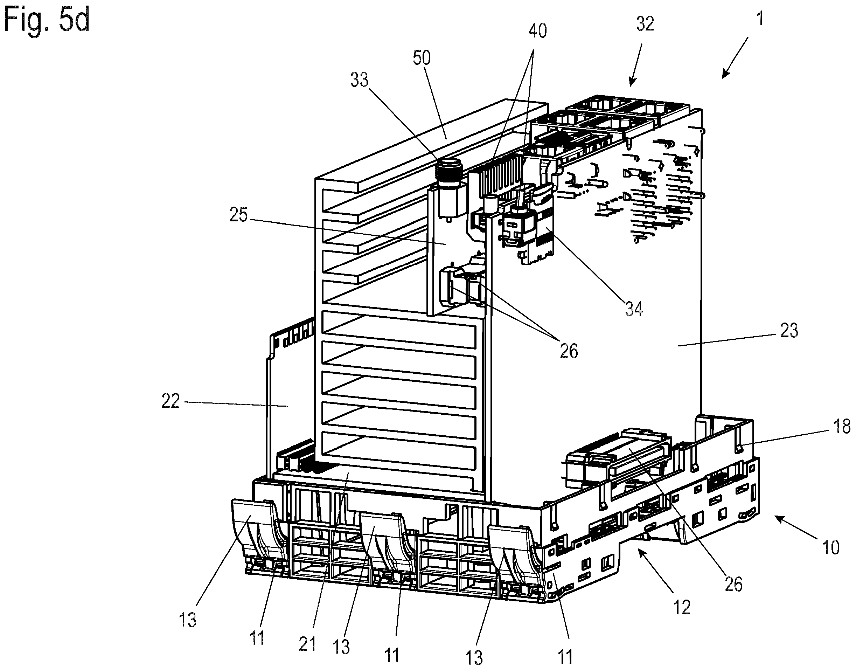

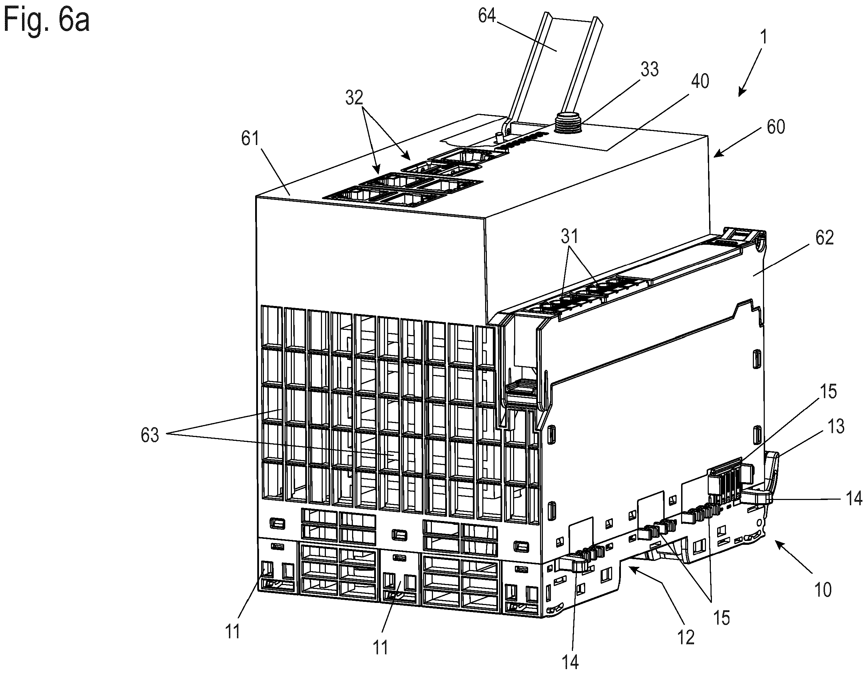

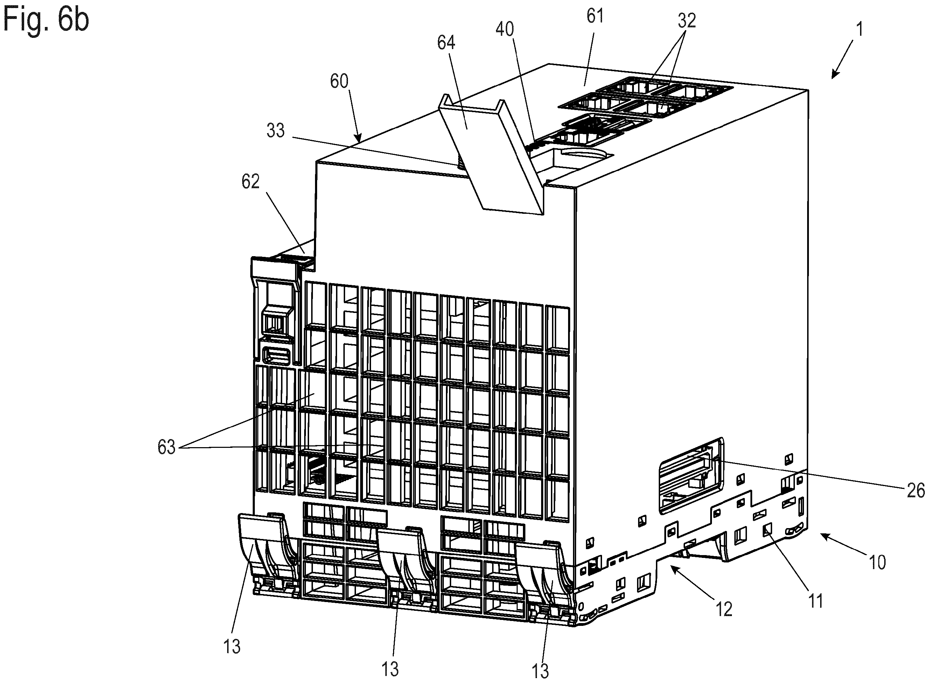

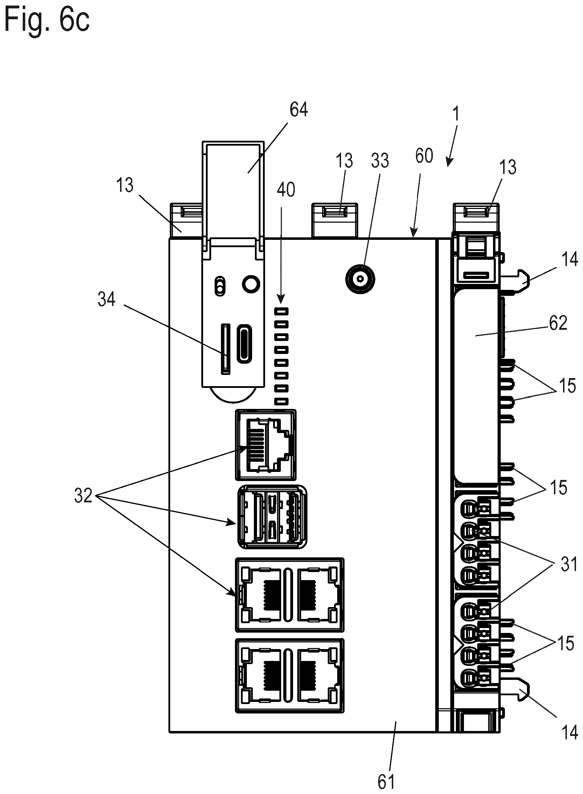

In den Fig. 5a bis 5d und 6a bis 6c ist ein weiteres Ausführungsbeispiel eines Hauptmoduls 1 eines Steuerungssystems dargestellt. Die Fig. 5a bis 5d zeigen das Hauptmodul 1 ohne aufgesetzten Gehäusedeckel 60, wohingegen die Fig. 6a bis 6c das Hauptmodul 1 mit aufgesetztem Gehäusedeckel 60 wiedergeben.

Auch bei diesem Ausführungsbeispiel ist der Sockel 10 des Hauptmoduls 1 wie in den vorherigen Ausführungsbeispielen ausgeführt, auf die hiermit verwiesen wird. Nachfolgend wird im Wesentlichen auf die Unterschiede zu den zuvor beschriebenen Ausführungsbeispielen eingegangen.

Bei dem hier gezeigten Ausführungsbeispiel ist neben der Anschlussleiterplatte 22 und der Rückwandbusleiterplatte 21 und ggf. verwendeten Zusatzleiterplatten 25 nur eine Hauptleiterplatte 23 und keine Ergänzungsleiterplatte 24 vorgesehen.

Um den zur Verfügung stehenden Platz bestmöglich ausnutzen zu können, ist die Hauptleiterplatte 23 im Bereich der linken Seite des Hauptmoduls 1 angeordnet. Die Schalt- und Signalelemente 40 sind wiederum entlang eines Abschnitts der oberen (bezogen auf die Darstellung in den Figuren) Kante der Hauptleiterplatte 23 positioniert. Bedingt durch die Anordnung der Hauptleiterplatte 23 seitlich im Hauptmodul 1 sind die zur Seite deutlich von der Hauptleiterplatte 23 abstehenden Schnittstellenanschlüsse 32 (wiederum insbesondere RJ-45 und USB-Anschlüsse) nach rechts hin im Hauptmodul 1 auf der Hauptleiterplatte 23 angeordnet. In einem Bereich unterhalb (wieder bezogen auf die Darstellung der Figu-ren) ist der Kühlkörper 50 bis nahe an die Hauptleiterplatte 23 herangeführt, um Wärme abgebende Komponenten der Hauptleiterplatte thermisch mit dem Kühlkörper 50 verbinden zu können und über den Kühlkörper 50 kühlen zu können. Im oberen Bereich des Kühlkörpers 50 ist dieser ausgeklinkt, um Platz für die Schittstellenanschlüsse 32 und die Zusatzleiterplatte 25 bereitstellen zu können. Bei geringerem Kühlbedarf kann ggf. auf den sich neben den Schnittstellenanschlüssen 32 befindenden Abschnitt des Kühlkörpers 50 verzichtet werden, so dass wiederum mehr Platz für die Zusatzleiterplatte 25 bzw. Platz für eine parallel zur Frontseite ausgerichtete Zusatzplatine 25 bereit zu stellen.

Ein weiterer Unterschied zu den vorherigen Ausführungsbeispielen betrifft die Ausgestaltung der Leiterplatten 20 im Bereich der Verbindung zwischen der Rückwandbusleiterplatte 21 und der Hauptleiterplatte 23.

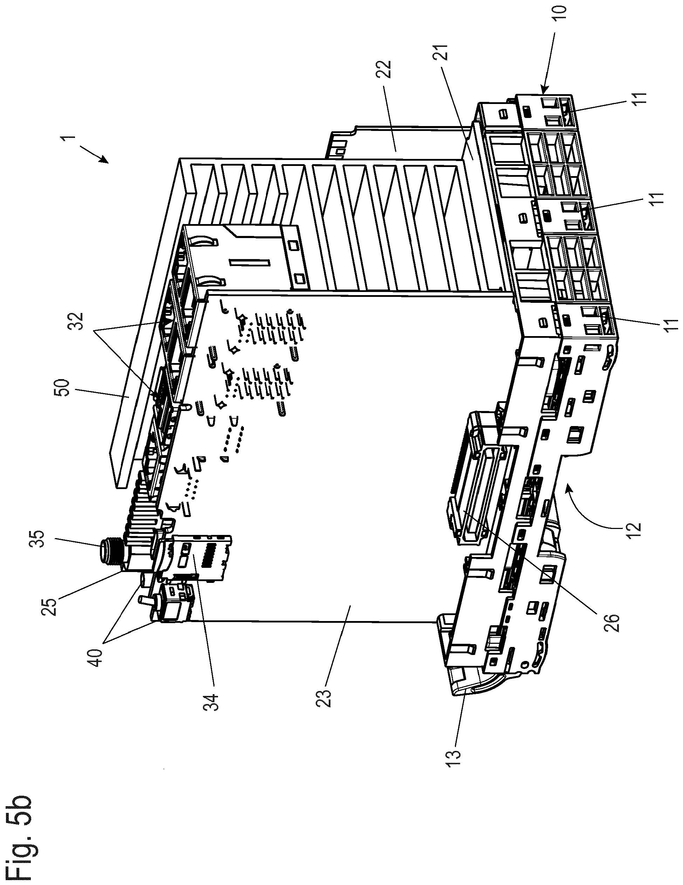

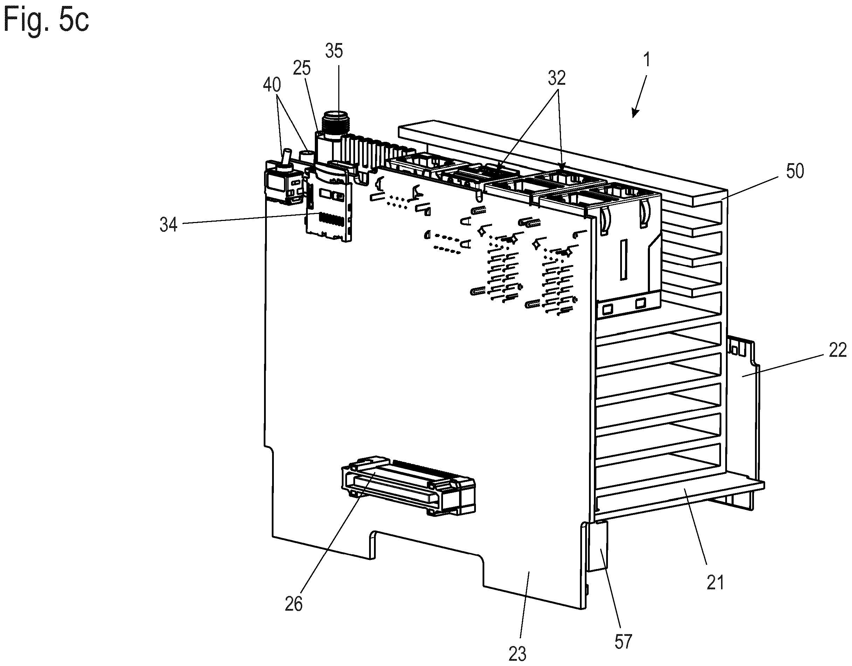

Wie aus Fig. 5b gut ersichtlich ist, mündet auf der linken Seite des Hauptmoduls A1 die Rückwandbusleiterplatte 21 wiederum in einem Steckkontakt, über den der Rückwandbus zu einsteckbaren Erweiterungsmodulen 2 übergeben werden kann. Die Rückwandbusleiterplatte 21 ist jedoch nur im Bereich dieses Steckkontaktes bis zum Rand des Grundrahmens 18 des Hauptmoduls 1 geführt. Im oberen und unteren Abschnitt (bezogen auf die Montageausrichtung des Hauptmoduls 1 im Schaltschrank) endet die Rückwandbusleiterplatte 21 vor der Hauptleiterplatte 23. Dadurch kann die Hauptleiterplatte 23 nach unten in den Sockel 10 verlängert werden, wodurch mehr Bestückungsfläche zur Verfügung steht. Der Bereich des Steckverbinders zu den Erweiterungsmodulen 2 ist dabei ausgespart. In der Fig. 5c ist das Hauptmodul 1 aus gleicher Blickrichtung wie bei Fig. 5b wiedergegeben, wobei jedoch der Sockel 10 entfernt ist, um die Hauptleiterplatte 23 in Ihrer gesamten Größe darstellen zu können. Diese Figur zeigt weiterhin, dass der Kühlkörper 50 mit einem Abschnitt, der als ein Montagefuß 57 bildet, ebenfalls bis in den Sockel 10 hineinragt, was seiner Befestigung dient.

Zusätzlich zu dem durchgeführten Steckverbinder zur Weitergabe des Rückwandbusses an die Erweiterungsmodule 2 ist ein hier nicht gezeigter Winkelverbinder angeordnet, der den Rückwandbus von der Hauptleiterplatte 23 auf die Rückwandbusleiterplatte 21 überträgt. Bei einer alternativen Ausgestaltung können beide Steckverbinder kombiniert sein, derart, dass die Hauptleiterplatte 23 auf Vorder- und Rückseite jeweils einen Steckverbinder aufweist, der einerseits mit einem entsprechenden Gegensteckverbinder auf der Rückwandbusleiterplatte 21 zusammenwirkt und den Rückwandbus zum Erweiterungsmodul 2 weiterleitet. Eine solche Anordnung von Steckverbindern wird auch als 180°-Steckverbinder bezeichnet.

Die größere Fläche der Hauptleiterplatte 23, die so erzielt werden kann, ermöglicht es, die wesentlichen Funktionen auf einer Leiterplatte unter zu bringen, wodurch die Ergänzungsleiterplatte 24 entfallen kann. Für die meisten benötigten Anwendungen wird eine ausreichende Leiterplattenfläche bei kompakten Gehäuseabmessungen bereit gestellt. Die in diesen Figuren gezeigte Variante stellt somit eine kostengünstige Version des Steuerungssystems dar. Die Ausbildung aller wesentlichen Komponenten auf der Hauptleiterplatte 23 bietet zudem den Vorteil, dass hochfrequent getaktete Signale über wenige Steckverbinder geführt werden, was einen guten Signalfluss und damit die Nutzung von hohen Taktfrequenzen zur Folge hat. Das Einsparen der Ergänzungsleiterplatte 24 wirkt sich zudem kostenreduzierend auf das System aus.

Ein weiterer kleiner Unterschied zu den zuvor gezeigten Ausführungsbeispielen liegt in der Zuordnung der Anschlüsse 30 und Schalt- und Signalelemente 40 auf die verschiedenen Leiterplatten 20. Beim vorliegenden Beispiel ist der Antennenanschluss 33 auf der Zusatzleiterplatte 25 angeordnet. Dieses ist vorteilhaft, wenn der Antennenanschluss 33 nicht zur Grundausstattung des Hauptmoduls 1 zählt, sondern entsprechend durch Nachrüstung der Zusatzleiterplatte 25 nachträglich hinzugefügt werden kann.

Auf der Hauptleiterplatte 23 ist bei diesem Ausführungsbespiel auch der Speicherkartenanschluss 34 ausgebildet. Alle zum Betrieb des Hauptmoduls notwendigen Anschlüsse und Funktionsbausteine können auf der Hauptleiterplatte 23 bzw der Rückwandbusleiterplatte 21 und der Anschlussleiterplatte 22 realisiert werden. Optionale Merkmale wie der Antennenanschluss 33 können dann über die Zusatzleiterplatte nachgerüstet werden. Wie bereits in Zusammenhang mit dem vorherigen Ausführungsbeispiel erwähnt ist, kann eine Pufferbatterie für eine Echtzeituhr des Systems zum Beispiel auf der Rückwandbusleiterplatte 21 Platz finden.

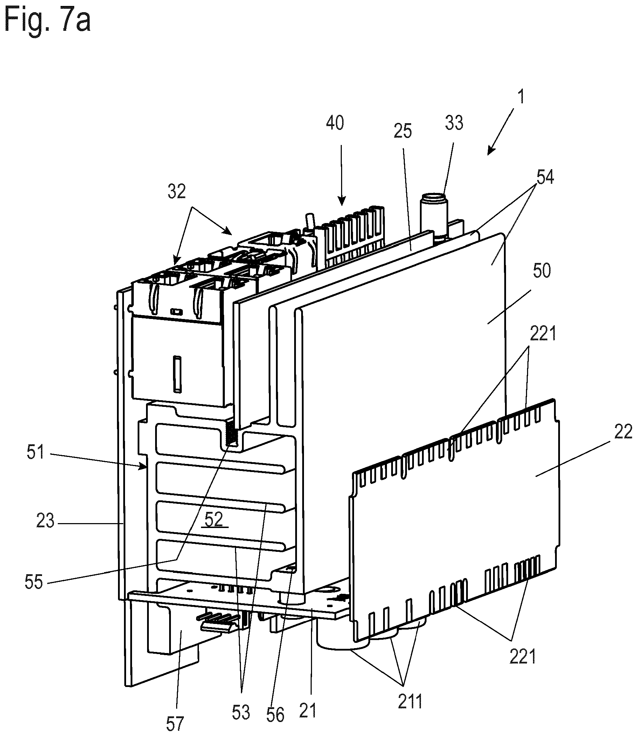

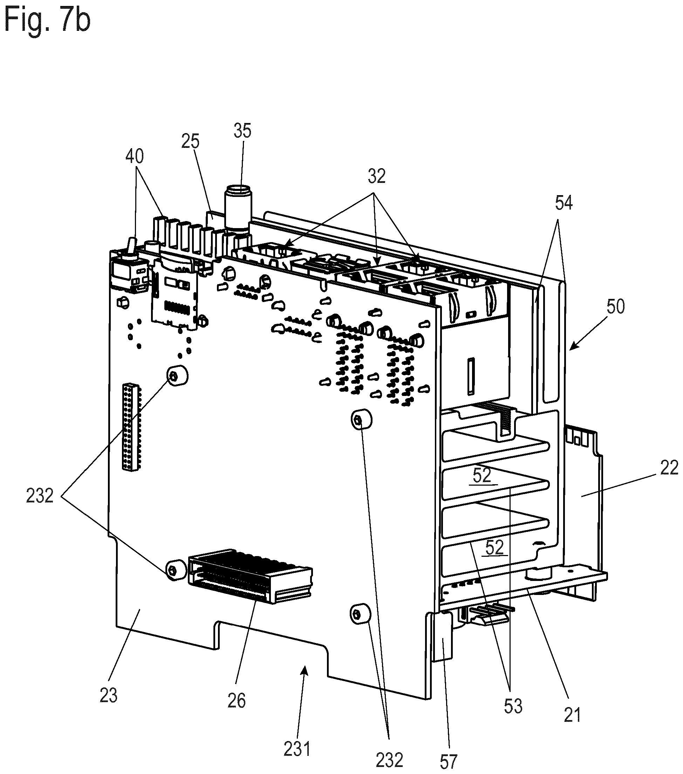

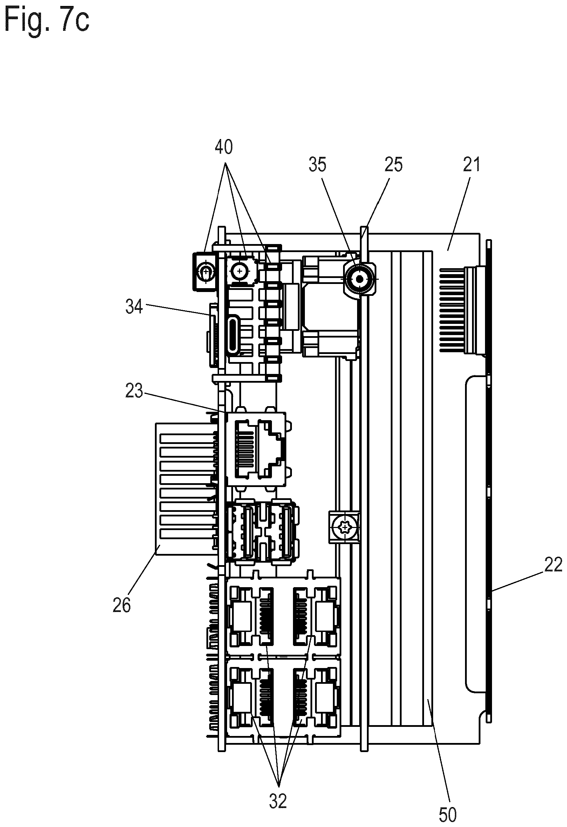

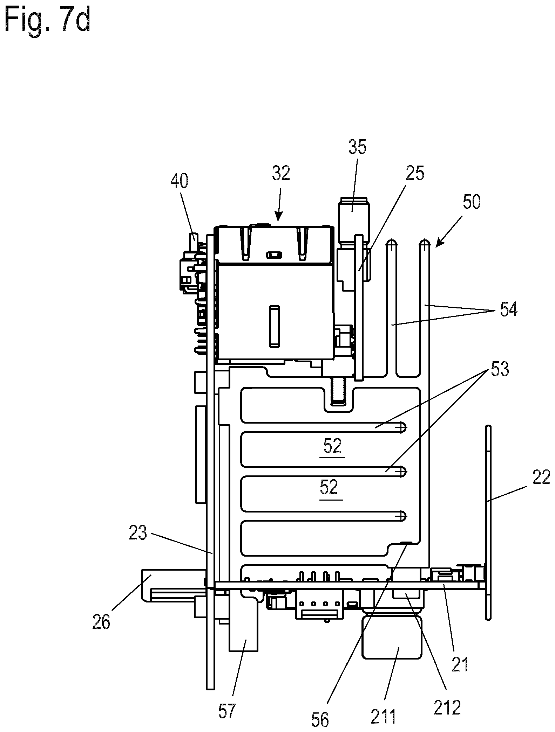

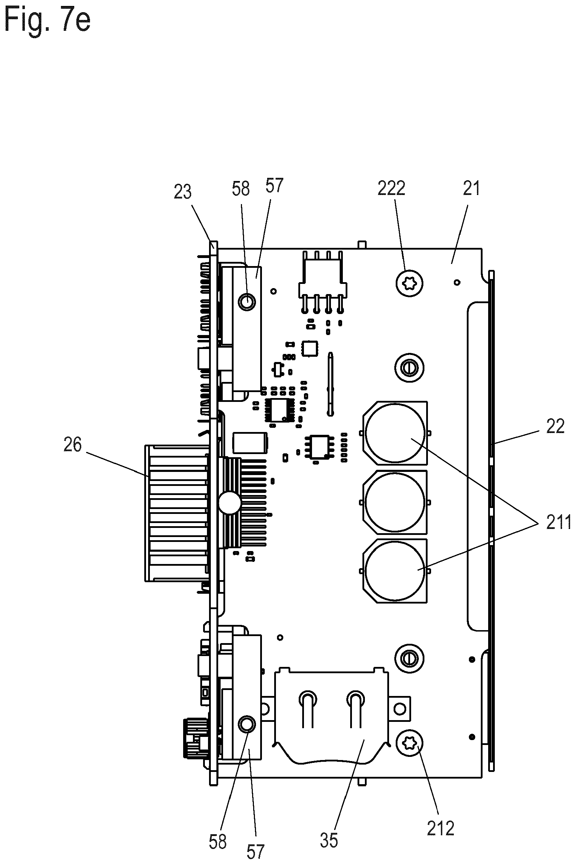

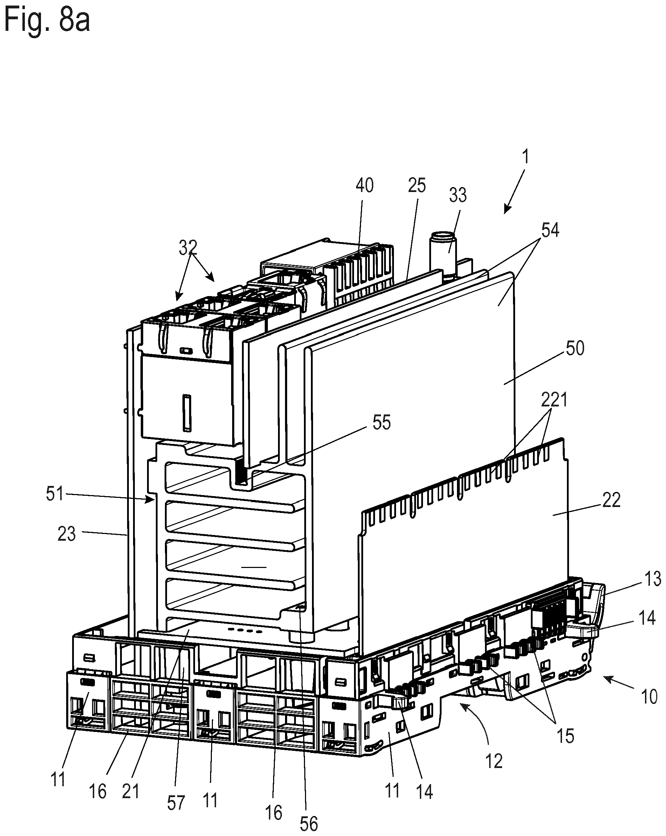

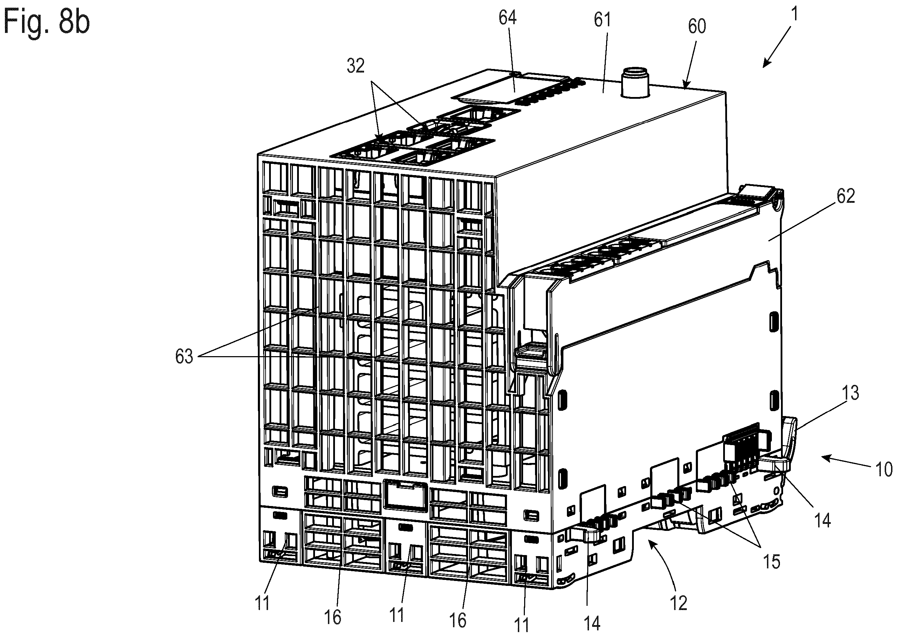

In den Fig. 7a bis e und 8a und 8b ist ein weiteres Ausführungsbeispiel eines Hauptmoduls 1 einer Steuerung in verschiedenen Ansichten dargestellt. Die Fig. 7a bis e zeigen das Hauptmodul 1 ohne Gehäuse. In Fig. 8a ist die in den Fig. 7a bis e gezeigte Anordnung in einen Sockel 10 eingesetzt. In Fig. 8b schließlich ist das vollständige Hauptmodul 1 mit Sockel 10 und aufgesetztem Gehäuseoberteil 60 dargestellt. Die Fig. 7a und 7b sind isometrische Schrägansichten auf Hauptmodul 1, das hier ohne Sockel 10 und ohne aufgesetzten Gehäusedeckel 60 gezeigt ist, die Fig. 7c zeigt eine Draufsicht auf das Hauptmodul 1, die Fig. 7d eine Seitenansicht und die Fig. 7e eine Draufsicht auf die Unterseite des Hauptmoduls 1, also eine Ansicht aus Richtung des hier nicht dargestellten Sockels 10.

Bezüglich des Grundaufbaus ist das in den Fig. 7a bis e und 8a, b gezeigte Hauptmodul 1 ebenso aufgebaut wie die in Zusammenhang mit den vorherigen Figuren beschriebenen Hauptmodule 1. Insbesondere ist wiederum eine Mehrzahl an Leiterplatten 20 vorhanden, konkret eine Rückwandbusleiterplatte 21, eine Anschlussleiterplatte 22, eine Hauptleiterplatte 23 und eine Zusatzleiterplatte 25. Die Rückwandbusleiterplatte 21 liegt wie bei den vorherigen Ausführungsbeispielen parallel zu einer Hutschiene, auf die das Hauptmodul 1 aufrastbar ist. Die Rückwandbusleiterplatte 21 liegt damit auch, wie Fig. 8a zeigt, auf dem Sockel 10 auf, der wiederum durch vorliegend 3 Rastträger 11, die durch Abstandselemente 16 voneinander beabstandet sind, aufweist. Gegenüber der Rückwandbusleiterplatte 21 sind die Hauptleiterplatte 23, die Anschlussleiterplatte 22 und die Zusatzleiterplatte 25 senkrecht angeordnet.

Wie bereits bei den zuvor gezeigten Ausführungsbeispielen ist der Kühlkörper 50 zentral im Hauptmodul 1 angeordnet und dient neben seiner Funktion zur Kühlung von Komponenten des Hauptmoduls 1 auch zur Halterung mehrere der Leiterplatten 20. Der Kühlkörper 50 stellt somit das zentrale und tragende Element des Hauptmoduls 1 dar. Er erstreckt sich über die gesamte Ausdehnung des Hauptmoduls 1 in einer Richtung senkrecht zur Hutschiene, d. h. in der Richtung, in der auch die Rastträger 11 verlaufen.

In dieser Richtung sind auch die Kühlkanäle 52 durch innere Finnen 53 gebildet. Bei Montage des Hauptmoduls 1 an einer Hutschiene verlaufen die Kühlkanäle 52 senkrecht, so dass durch Konvektion ein Kühlluftzug durch die Kühlkanäle 52 einsetzt. Wenn erforderlich, kann wie im Zusammenhang mit dem Ausführungsbeispiel der Fig.1 beschrieben ein Lüfter beispielsweise außen am Gehäuse 60 aufgesetzt werden, der einen Luftzug durch die Lüftungsdurchbrüche 63 und die Kühlkanäle 52 verstärkt.

In einem unteren Bereich des Kühlkörpers 50, der etwa die Hälfte oder etwas über der Hälfte der Bauhöhe einnimmt, sind die inneren Kühlfinnen 53 parallel zur Rückwand der Leiterplatte 21 ausgebildet. Sie leiten damit Wärme von der Kühlfläche 51 ab, die parallel zur Hauptleiterplatte 23 verläuft. Die inneren Finnen 53 reichen bei diesem Beispiel nicht zur gegenüberliegenden Wand des Kühlkörpers 50, um dessen Herstellung in einem Strang-Druckgussprozess zu vereinfachen.

Mit dieser Kühlfläche 51 stehen elektronische Komponenten, die auf der zum Kühlkörper 50 weisenden Seite der Hauptleiterplatte 23 angeordnet sind, in thermischen Kontakt. Die Kühlfläche 51 kann dabei gestuft ausgebildet sein und Plateaus in verschiedenen Höhen aufweisen, um unterschiedlich hohe Bauelemente der Hauptleiterplatte gleichermaßen gut zu kontaktieren.

In einem in den Figuren oberen Bereich des Kühlkörpers 50 ist der ansonsten quaderförmige Umriss des Kühlkörpers 50 ausgespart, um Platz für die Schnittstellenanschlüsse 32 und/oder Schalt- und Signalelemente 40, die auf der Hauptleiterplatte 23 angeordnet sind, bereit zu stellen. Im verbleibenden Abschnitt des Kühlkörpers 50 sind äußere Kühlfinnen 54 parallel zur Hauptleiterplatte 23 ausgerichtet. Sie stehen damit auch parallel zur Zusatzleiterplatte 25, die beispielsweise Module zur drahtlosen Kommunikation aufnimmt und einen Antennenanschluss 33 trägt. Auf der Zusatzleiterplatte 25 zu kühlende Elemente können mit der benachbarten Kühlfinne 54 gekoppelt sein. Im Bereich der Aussparung ist eine Befestigungsnut 55 im Kühlkörper 50 vorgesehen, die der Befestigung der Leiterplatte 25 dient.

Wie bei den zuvor beschriebenen Ausführungsbeispielen ist auch bei diesem Beispiel die Hauptleiterplatte 23 an dem Kühlkörper 50 montiert. Beispielsweise sind in Fig. 7b Befestigungsschrauben 232 zu erkennen, die durch die Hauptleiterplatte 23 führen und in entsprechende Gewindebohrungen des Kühlkörpers 50 eingeschraubt sind. Darüber hinaus ist auch die Rückwandbusleiterplatte 21 mit dem Kühlkörper 50 verschraubt, der zu diesem Zweck Befestigungsbohrungen 56 aufweist, die beispielsweise in Fig. 7a zu erkennen sind. Die Rückwandbusleiterplatte 21 und die Hauptleiterplatte 23, ebenso wie die Zusatzleiterplatte 25 bilden so mit dem Kühlkörper 50 zusammen eine vormontierte Baugruppe, die elektrisch in sich funktionsfähig ist und die als Ganzes in den Sockel 10 zur Montage eingesetzt wird.

Zur Montage der genannten Einheit in dem Sockel 10 weist der Kühlkörper 50 vergleichbar mit dem Ausführungsbeispiel der Fig. 5a-d bzw. 6a-c Montagefüße 57 auf, mit denen er durch eine Aussparung am Rand der Rückwandbusleiterplatte 21 bis in den Bereich des Sockels 10 hinein ragt. Im Sockel 10 sind bevorzugt Führungen für die Montagefüße 57 ausgebildet, die einen eingesetzten Kühlkörper 50 seitlich formschlüssig aufnehmen. Wie insbesondere in Fig. 7b gut zu sehen ist, ist bei dem dargestellten Ausführungsbeispiel auch die Hauptleiterplatte 23 über die Ebene der Rückwandbusleiterplatte 21 hinaus nach unten in Richtung des Sockels 10 fortgeführt und ragt wie die Montagefüße 57 in den Sockel 10 hinein. Auf diese Weise wird zusätzlicher Bestückungsraum auf der Hauptleiterplatte 23 geschaffen, ohne die Bauhöhe des Hauptmoduls 1, d. h. die Höhe über der Hutschiene, zu vergrößern.

Im Bereich der Hutschiene selbst bzw. der Hutschienenaufnahme 12 des Sockels 10 ist eine Aussparung 231 vorhanden. Die Ansicht auf die Unterseite der Rückwandbusleiterplatte 21 in Fig. 7e zeigt die nach unten durchgeführten Montagefüße 57 mit jeweils einer Montagebohrung 58, mittels derer der eingesetzte Kühlkörper 50 von unten mit dem Sockel verschraubt werden kann. In dieser Abbildung sind zudem Bauelemente 211 der Rückwandbusleiterplatte 21 zu erkennen, die ebenfalls nach unten in den Sockel 10 hinein ragen und so dessen Volumen mit nutzen. In der Abbildung sind weiterhin Befestigungsschrauben 212 zu erkennen, mit denen die Rückwandbusleiterplatte 21 mit dem Kühlkörper 50 verschraubt ist.

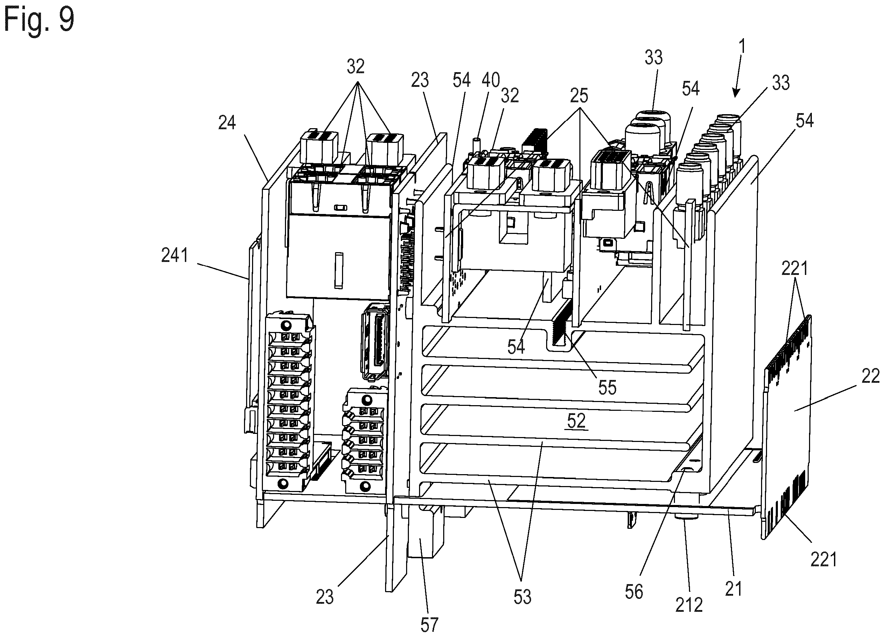

In Fig. 9 ist ein weiteres Ausführungsbeispiel eines Hauptmoduls 1 einer Steuerung dargestellt. Vergleichbar mit Fig. 8a ist eine isometrische Schrägansicht des Hauptmoduls 1 wiedergegeben, wobei ein Sockel 10 und ein aufgesetzter Gehäusedeckel 60 in dieser Figur nicht wiedergegeben sind.

Vom Grundaufbau entspricht das in Fig. 9 dargestellte Ausführungsbeispiel dem der Fig. 7a-7e und 8a, b, insbesondere was die Montage des Kühlkörpers 50 betrifft. Auch bei diesem Ausführungsbeispiel weist dieser nach unten in den Sockel 10 hereinragende Montagefüße 57 auf. Mit dem Kühlkörper 50 sind die Hauptplatine 23 und auch die Rückwandbusplatine 21 verbunden, beispielsweise über die in der Fig. 9 sichtbaren Befestigungsschrauben 212.

Ebenfalls wie bei dem zuvor beschriebenen Ausführungsbeispiel sind beim Kühlkörper 50 in einem unteren, der Rückwandbusleiterplatte 21 benachbarten Abschnitt innere Kühlfinnen 53 parallel zur Rückwandbusleiterplatte 21 ausgebildet und im oberen, von der Rückwandbusleiterplatte 21 entfernt liegenden Teil des Kühlkörpers 50 äußere Kühlfinnen 54 senkrecht zur Rückwandbusleiterplatte 21 ausgerichtet.

Im Unterschied zum zuvor beschriebenen Ausführungsbeispiel ist der Kühlkörper 50 in Richtung der Hutschiene breiter ausgebildet. Insgesamt sind vier äußere Kühlfinnen 54 parallel zur Hauptleiterplatte 23 vorhanden und sind über die gesamte Breite des Kühlkörpers 50 verteilt. Zwischen den Kühlfinnen 54 befinden sich drei Zwischenräume, in denen jeweils eine Zusatzleiterplatte 25 vorhanden ist. Zur Befestigung zumindest einem Teil dieser Zusatzleiterplatten 25 ist wiederum eine Befestigungsnut 55 im Kühlkörper 53 vorhanden, in die flexibel positionierbar Befestigungsschrauben eingeschraubt werden können.

Um elektrische Verbindungen zwischen der Hauptleiterplatte 23 und den Zusatzleiterplatten 25 bzw. zwischen verschiedenen der Zusatzleiterplatten 25 vornehmen zu können, sind drei der vier genannten äußeren Finnen 54, zwischen denen die Zusatzleiterplatten 25 positioniert sind, nicht über die gesamte Ausdehnung des Kühlkörpers 50 ausgebildet. Konkret enden die erste und dritte der genannten Kühlfinnen 54 in Fig. 9 vor dem hinteren, nicht sichtbaren Ende des Kühlkörpers. Die (wiederum von links gesehen) zweite der Kühlfinnen 54 reicht an beiden Seiten nicht an den sonstigen Umriss des Kühlkörpers 50 heran. Die zwischen der Hauptplatine 23 und den Zusatzplatinen 25 bzw. zwischen den Zusatzplatinen 25 untereinander ausgeführten Verbindungen können Steckverbinder verschiedenster Art sein. Neben Leiterplattensteckverbindern können insbesondere zur Übertragung von Hochfrequenzsignalen auch Kabelsteckverbinder vorgesehen sein. Beispielsweise trägt die in der Fig. 9 rechte Zusatzplatine 25 eine Anzahl von Antennenanschlüssen 33, die gemäß dem SMA (Sub-Miniature-A)-Standard ausgebildet sind. Diese Antennenanschlüsse 33 bedienende Elektronikkomponenten können beispielsweise auch auf der benachbarten Zusatzplatine, die ebenfalls Antennenanschlüsse 33 trägt, angeordnet sein, wobei Hochfrequenzsignale über Miniaturhochfrequenzstecker zwischen den beiden Zusatzplatinen ausgetauscht werden. Geeignete Miniaturhochfrequenzsteckverbinder sind beispielsweise UMTC (Ultra-Miniature-Telecommunications-Connector)-Verbinder.

Ein weiterer Unterscheid des Ausführungsbeispiels der Fig. 9 gegenüber dem zuvor beschriebenen liegt im Vorhandensein einer Ergänzungsleiterplatte 24, die die Funktionalität der Hauptleiterplatte 23 ergänzt. Diese ist parallel zur Hauptleiterplatte 23 angeordnet und steht mit dieser über einen Leiterplattenverbinder, der in der Ebene der Rückwandbusleiterplatte 21 ausgebildet ist, in Verbindung. Auf der Ergänzungsleiterplatte 24 sind beispielsweise Speichermodule 241 auf der der Hauptleiterplatte 23 gegenüberliegende Seiten der Ergänzungsleiterplatte 24 angeordnet. Die Speichermodule 241 sind damit nach Abnahme des hier nicht dargestellten Gehäusedeckels 60 zugänglich, um ergänzt oder ausgetauscht werden zu können.

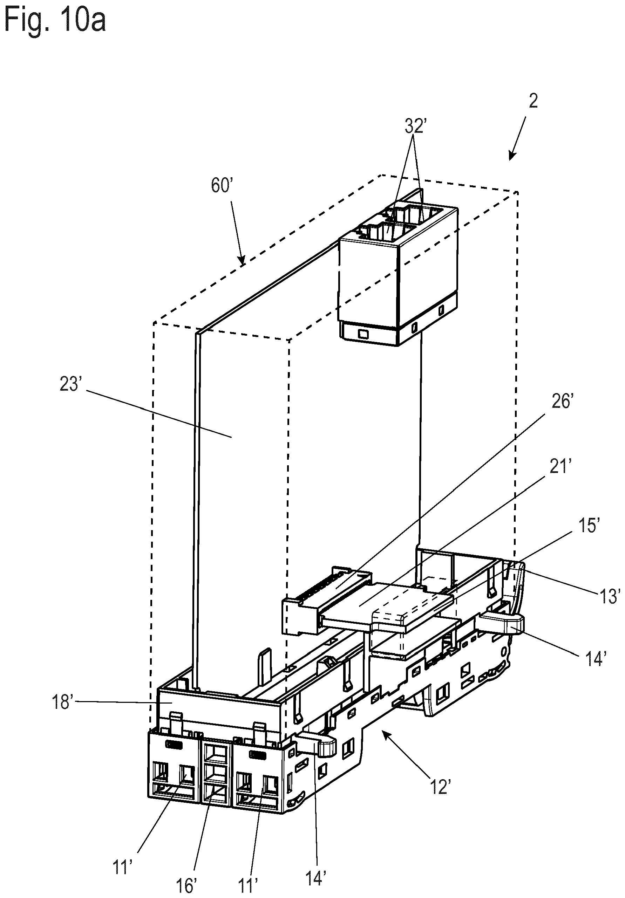

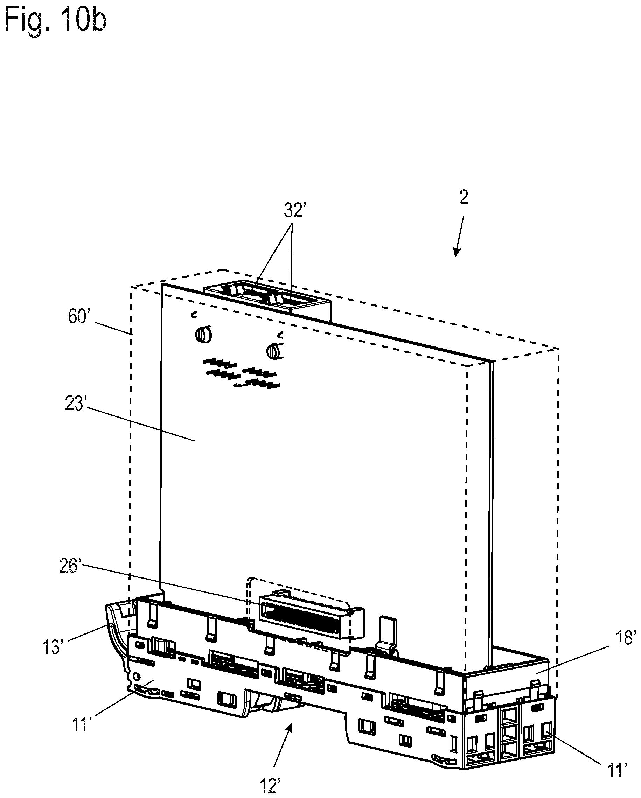

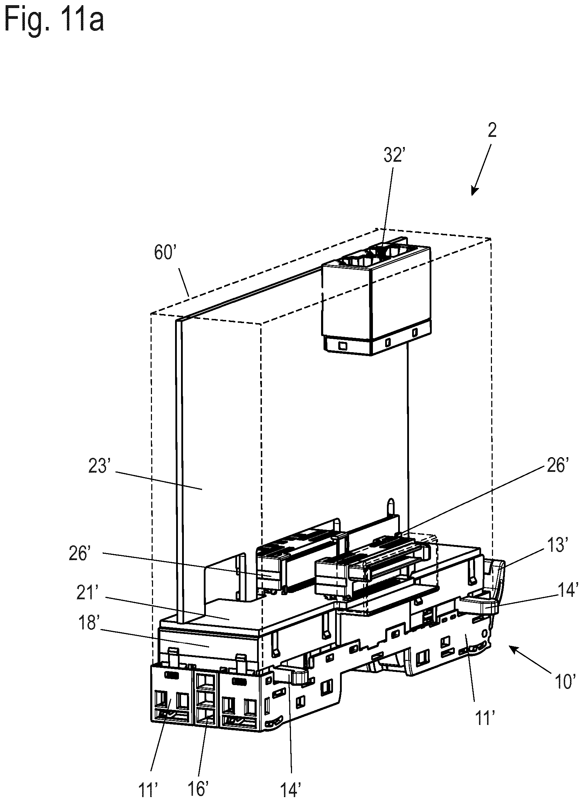

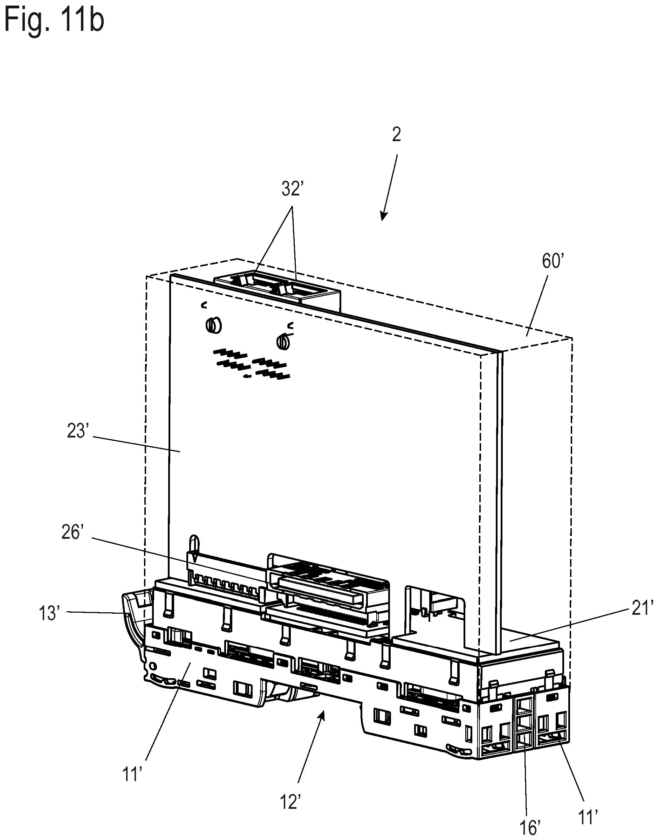

In den Fig. 10a und 10b sowie 11a und 11b sind jeweils isometrische Ansichten aus verschiedenen Richtungen von zwei Beispielen eines Erweiterungsmoduls 2 für ein Steuerungssystem dargestellt. Das erste, in den Fig. 10a und 10b gezeigte Beispiel ist auch in dem Steuerungssystem der Fig. 1 gezeigt. Das zweite, in den Fig. 11a und 11b wiedergegebene Beispiel des Erweiterungsmoduls 2 wird beim Beispiel der Fig. 2a bis 2c eingesetzt.

Beim ersten Beispiel der Fig. 10a und 10b ist eine senkrecht angeordnete Hauptleiterplatte 23' vorgesehen, die an ihren oberen (in den Figuren), also zur Frontseite weisenden Kante Anschlüsse 30' aufweist, konkret Schnittstellenanschlüsse 32'.

In einem dem Sockel 10 benachbartem Abschnitt der Hauptleiterplatte 23' ist ein sogenannter 180°-Steckverbinder angeordnet, der Steckkontakte zu beiden Seiten der Hauptleiterplatt 23' bereit stellt. In diesem Steckverbinder ist zur rechten Seite hin eine Rückwandbusleiterplatte 21' eingesetzt, die bis zu einem Ausschnitt in der in der Figur durchscheinend dargestellten Gehäusedeckel 60' reicht. Beim Anstecken des Erweiterungsmoduls 2 an ein Hauptmodul 1 kontaktiert diese Rückwandbusleiterplatte 21' einen entsprechenden Steckverbinder im Hauptmodul 1. Gleichzeitig wird auf der linken Seite des Erweiterungsmoduls 2 ein ähnlicher Steckverbinder zur Kontaktierung weiterer Erweiterungsmodule 2 bereit gestellt.

Das in den Fig. 11a und 11b gezeigte Beispiel unterscheidet sich von dem ersten dahingehend, dass ähnlich wie beim Hauptmodul 1 eine Rückwandbusleiterplatte 21' vorgesehen ist, die parallel zur Montageseite bzw. Frontseite ausgerichtet ist und die an jeder der Seiten des Erweiterungsmoduls 2 einen Steckverbinder aufweist. Senkrecht auf die Rückwandbusleiterplatte 21 ` ist die Hauptleiterplatte 23' aufgesetzt und mit dieser über einen weiteren Steckverbinder elektrisch verbunden. Ein Abschnitt der Hauptleiterplatte 23' ragt dabei bis in den Sockel 10 hinein, wodurch beispielsweise eine Erdkontaktierung über eine im Sockel 10 angeordnete Kontaktfeder zur Hutschiene erfolgen kann.

Die Erweiterungsmodule 2 erweitern das Steuerungssystem um zusätzliche Schnittstellen oder auch um Applikationsmodule. Applikationsmodule können Funktionen oder auch Kombinationen von Schnittstellen enthalten. Applikationsmodule fassen Funktionen für konkrete Anwendungsgebiete zusammen. Die unmittelbare Anbindung der Erweiterungsmodule 2 an dem Rückwandbus des Hauptmoduls 1 ermöglicht es, eine hohe Datenrate über die Erweiterungsmodule 2 auszutauschen. Die Erweiterungsmodule 2 können in dem Sinne auch als "High-Speed Module" angesehen werden oder können ein Ausgabemodul für besonders kurze Schaltzeiten bilden. Zur Erweiterung des Funktionsumfangs des Steuerungssystems können die Erweiterungsmodule 2 auch als Speichermodule, als Repeater, als Kameramodule, als Gateways, als Multiplayer oder als Switch, als Medienkonverter, als Router zur Datenanalyse (z. B. Predective Analytics) oder zur Bereitstellung von Sicherheitsfunktionen (Safety) dienen.

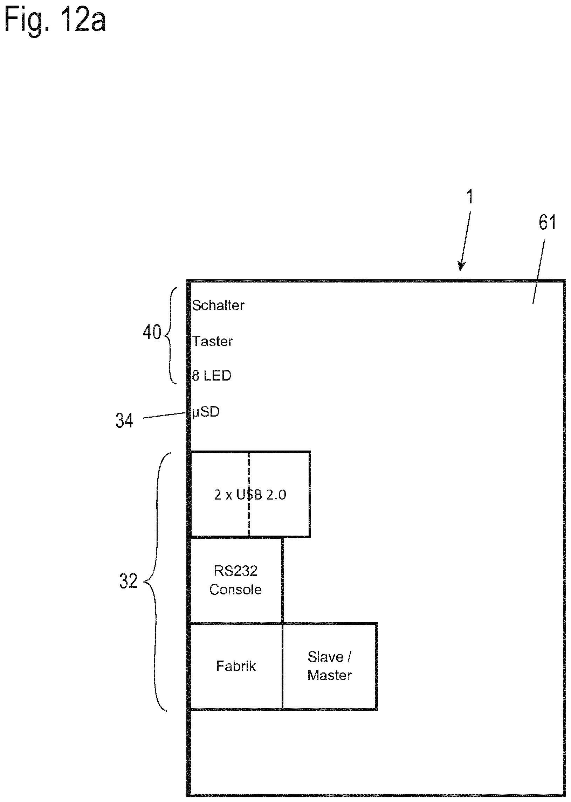

Die Fig. 12a bis 12c zeigen jeweils eine schematische Aufsicht auf die Frontseite (nur im Bereich des Hauptdeckels 61) des Hauptmoduls 1.

Schematisch und nicht in der exakten geometrischen Position sind verschiedene mögliche Konstellationen der Frontseite mit Anschlüssen 30 und Schalt und Signalelementen 40 wiedergegeben. Die verschiedenen Ausgestaltungen der Fig. 12a bis 12c unterscheiden sich in Art der Anschlüsse 30 bzw. Schalt- und Signalelemente 40 sowie insbesondere der Dichte mit der diese Anschlüsse 30 und Schalt- und Signalelemente 40 an der Frontseite angeordnet sind.

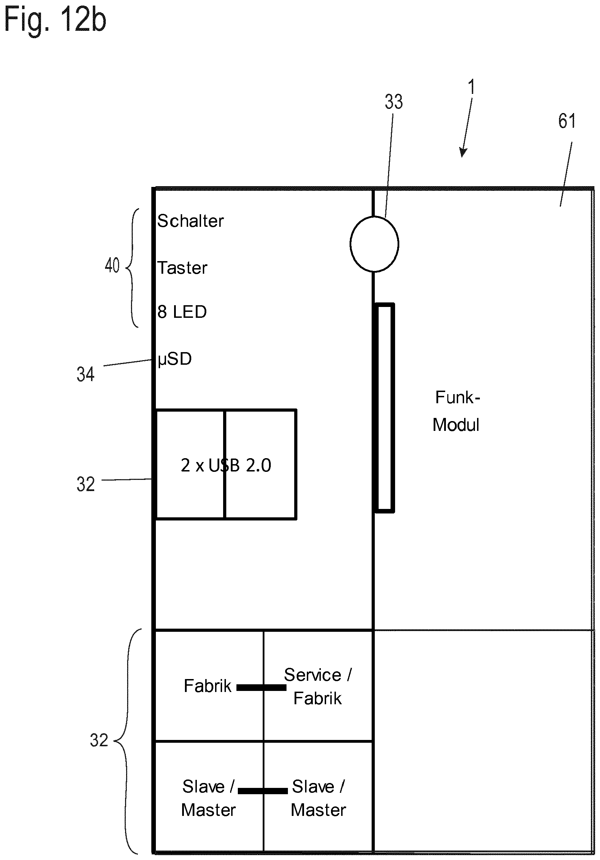

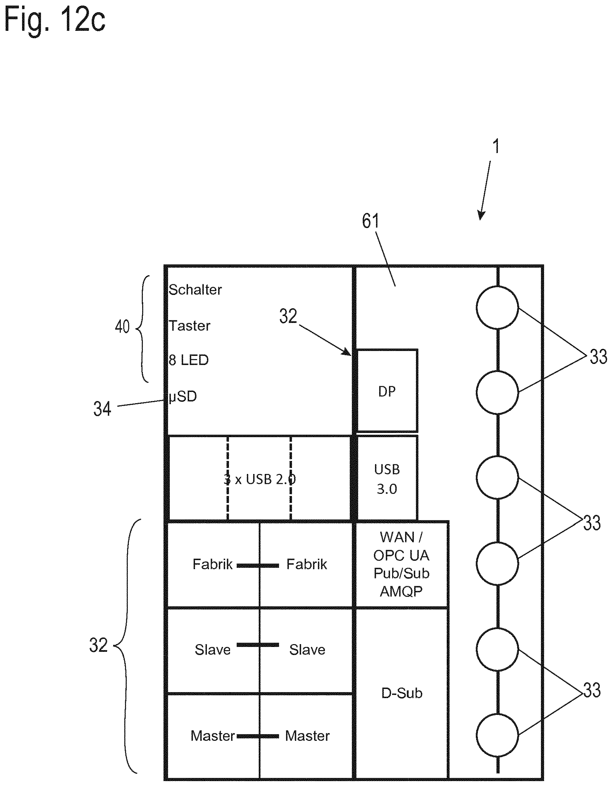

Die in den Fig. 12a und 12b gezeigten Ausführungsbeispiele sind z.B. mit dem Grundaufbau aller zuvor gezeigten Ausführungsbeispiele eines Hauptmoduls 1 erzielbar. Die in Fig. 12c gezeigte Konfiguration mit einer sehr hohen Dichte an Anschlüssen 30 und Schalt- und Signalelementen 40 ist bevorzugt mit den Ausführungsbeispielen der Fig. 3a und 3b und 4a bis 4c sowie 9 umsetzbar, da bei diesen Ausführungsbeispielen neben der Hauptleiterplatte 23 die Ergänzungsleiterplatte 24 zur Verfügung steht, um insbesondere weitere Schnittstellenanschlüsse 32 aufzunehmen.

### Bezugszeichen

- 1: Hauptmodul
- 2: Erweiterungsmodul
- 3: Ein- / Ausgabemodul

- 10: Sockel
- 11: Rastträger
- 12: Hutschienenaufnahme
- 13: Entriegelungshebel
- 14: Rasthaken
- 15: Buskontakte
- 16: Abstandselement
- 17: Leiterplattenträger
- 18: Grundrahmen
- 19: Montagedom

- 20: Leiterplatten
- 21: Rückwandbusleiterplatte
- 211: Bauelement
- 212: Befestigungsschraube
- 22: Anschlussleiterplatte
- 221: Leiterplattenrandkontakte

- 23: Hauptleiterplatte
- 231: Aussparung für Hutschiene
- 232: Befestigungsschraube
- 24: Ergänzungsleiterplatte
- 25: Zusatzleiterplatte
- 26: Steckverbinder

- 30: Anschlüsse
- 31: Stromversorgungsanschluss
- 32: Schnittstellenanschluss
- 33: Antennenanschluss
- 34: Speicherkartenanschluss
- 35: Batterieanschluss

- 40: Schalt- und Signalelemente

- 50: Kühlkörper
- 51: Kühlfläche
- 52: Kühlkanal
- 53: innere Kühlfinne
- 54: äußere Kühlfinne
- 55: Befestigungsnut
- 56: Befestigungsbohrung
- 57: Montagefuß
- 58: Montagebohrung

- 60: Gehäusedeckel
- 61: Hauptdeckel
- 62: Klappleiste
- 63: Lüftungsdurchbruch
- 64: Zugangsklappe

## Patentansprüche

1. Steuerung für ein industrielles Automatisierungssystem, aufweisend ein Hauptmodul (1) mit einem Gehäuse, das einen Sockel (10) umfasst, mit dem es auf eine Hutschiene aufsetzbar ist, und mit mindestens zwei in dem Gehäuse angeordneten Leiterplatten (20), von denen eine eine Rückwandbusleiterplatte (21) und eine eine Hauptleiterplatte (23) ist, wobei der Hauptleiterplatte (23) ein Kühlkörper (50) zur Kühlung von Komponenten zugeordnet ist und wobei die Rückwandbusleiterplatte (21) einen Rückwandbus für mindestens ein seitlich anreihbares Erweiterungsmodul (2) bereitstellt, **dadurch gekennzeichnet, dass** der Kühlkörper (50) in dem Gehäuse angeordnet ist, an dem Sockel (10) befestigt ist und mindestens eine der Leiterplatten (20) trägt.

2. Steuerung nach Anspruch 1, bei der der Kühlkörper (50) einen im wesentlich quaderförmigen Umriss aufweist und mit zwei zueinander senkrechten Außenflächen parallel zu der Hauptleiterplatte (23) und der Rückwandbusleiterplatte (21) steht.

3. Steuerung nach Anspruch 1 oder 2, bei der zumindest eine Außenfläche des Kühlkörpers (50) als Kühlfläche (51) ausgebildet ist, mit der die Komponenten der Hauptleiterplatte (23) in thermischem Kontakt stehen.

4. Steuerung nach einem der Ansprüche 1 bis 3, bei dem die Rückwandbusleiterplatte (21) flach auf oder in dem Sockel angeordnet ist, so dass sie parallel zu einer Hutschiene, auf die das Hauptmodul (1) aufgesetzt ist, ausgerichtet ist.

5. Steuerung nach einem der Ansprüche 1 bis 4, bei der die Hauptleiterplatte (23) und die Rückwandbusleiterplatte (21) an dem Kühlkörper (50) befestigt sind.

6. Steuerung nach Anspruch 4 und 5, bei der der Kühlkörper (50) mindestens einen Montagefuß (57) aufweist, der bis in den Sockel (10) hineinragt und dort befestigt ist.

7. Steuerung nach Anspruch 6, bei der der Kühlkörper (50), die Hauptleiterplatte (23) und die Rückwandbusleiterplatte (21) eine vormontierbare Baugruppe bilden, die als Ganzes an dem Sockel (10) befestigt ist.

8. Steuerung nach Anspruch 7, bei der die Baugruppe nur mit dem mindestens einen Montagefuß (57) an dem Sockel (10) befestigt ist.

9. Steuerung nach einem der Ansprüche 1 bis 8, bei der der Kühlkörper (50) innere Kühlfinnen (53) aufweist, durch die Kühlkanäle (52) ausgebildet sind.

10. Steuerung nach Anspruch 9, bei der die inneren Kühlfinnen (53) senkrecht zu der Hauptleiterplatte (23) verlaufen.

11. Steuerung nach einem der Ansprüche 1 bis 10, bei der der Kühlkörper (50) äußere Kühlfinnen (54) aufweist, neben denen mindestens eine Zusatzleiterplatte (25) angeordnet ist.

12. Steuerung nach Anspruch 11, bei der die äußeren Kühlfinnen (54) parallel zu der Hauptleiterplatte (23) verlaufen.

13. Steuerung nach Anspruch 11 oder 12, bei der zumindest eine der äußeren Kühlfinnen (54) in einer Längsrichtung kürzer ist als andere Abschnitte des Kühlkörpers (50).

14. Steuerungssystem mit einer Steuerung mit einem Hauptmodul (1) nach einem der Ansprüche 1 bis 13, wobei das Hauptmodul (1) über eine Rückwandbusleiterplatte (21) mit mindestens einem angereihten Erweiterungsmodul (2) verbunden ist.

## Claims

1. A controller for an industrial automation system, having a main module (1) with a housing that includes a base (10) with which it can be fitted on a DIN rail, and with at least two printed circuit boards (20) which are arranged in the housing, one of these printed circuit boards (20) being a backplane bus printed circuit board (21) and one being a main printed circuit board (23), wherein the main printed circuit board (23) is assigned a heat sink (50) for the cooling of components and wherein the backplane bus printed circuit board (21) provides a backplane bus for at least one expansion module (2) that can be arranged laterally, **characterised in that** the heat sink (50) is arranged in the housing, is attached to the base (10) and supports at least one of the printed circuit boards (20).

2. Controller according to Claim 1, in which the heat sink (50) has a substantially parallelepipedal outline and, with two mutually perpendicular outer surfaces, lies parallel to the main printed circuit board (23) and the backplane bus printed circuit board (21).

3. Controller according to Claim 1 or 2, in which at least one outer surface of the heat sink (50) is formed as a cooling surface (51), with which the components of the main printed circuit board (23) are in thermal contact.

4. Controller according to any one of Claims 1 to 3, in which the backplane bus printed circuit board (21) is arranged flat on or in the base, such that it is oriented parallel to a DIN rail onto which the main module (1) is fitted.

5. Controller according to any one of Claims 1 to 4, in which the main printed circuit board (23) and the backplane bus printed circuit board (21) are attached to the heat sink (50).

6. Controller according to Claim 4 and 5, in which the heat sink (50) has at least one mounting foot (57), which protrudes into the base (10) and is attached there.

7. Controller according to Claim 6, in which the heat sink (50), the main printed circuit board (23) and the backplane bus printed circuit board (21) form a premountable assembly, which is attached as a whole to the base (10).

8. Controller according to Claim 7, in which the assembly is only attached to the at least one mounting foot (57) on the base (10).

9. Controller according to any one of Claims 1 to 8, in which the heat sink (50) has inner cooling fins (53), by means of which cooling channels (52) are formed.

10. Controller according to Claim 9, in which the inner cooling fins (53) run perpendicular to the main printed circuit board (23).

11. Controller according to any one of Claims 1 to 10, in which the heat sink (50) has outer cooling fins (54), beside which at least one additional printed circuit board (25) is arranged.

12. Controller according to Claim 11, in which the outer cooling fins (54) run parallel to the main printed circuit board (23).

13. Controller according to Claim 11 or 12, in which at least one of the outer cooling fins (54), in a longitudinal direction, is shorter than other sections of the heat sink (50).

14. A control system with a controller having a main module (1) according to any one of Claims 1 to 13, wherein the main module (1) is connected to at least one stacked expansion module (2) via a backplane bus printed circuit board (21).

## Revendications

1. Unité de commande pour un système d'automatismes industriel, comportant un module principal (1) avec un boîtier qui comprend une embase (10) avec laquelle il peut être posé sur un rail oméga et avec au moins deux cartes de circuits (20) disposées dans le boîtier, dont l'une est une carte de circuits de bus de fond de panier (21) et une autre une carte de circuits principale (23), la carte de circuits principale (23) étant associée à un radiateur (50) pour le refroidissement de composants et la carte de circuits de bus de fond de panier (21) fournissant un bus de fond de panier pour au moins un module d'extension (2) qui peut être monté en série sur le côté, **caractérisée en ce que** le radiateur (50) est disposé dans le boîtier, fixé à l'embase (10), et porte au moins une des cartes de circuits (20).

2. Unité de commande selon la revendication 1, dans laquelle le radiateur (50) présente un contour sensiblement quadrangulaire et deux de ses surfaces extérieures perpendiculaires l'une à l'autre sont parallèles à la carte de circuits principale (23) et à la carte de circuits de bus de fond de panier (21).

3. Unité de commande selon la revendication 1 ou 2, dans laquelle au moins une surface extérieure du radiateur (50) est conformée comme une surface de refroidissement (51) avec laquelle les composants de la carte de circuits principale (23) sont en contact thermique.

4. Unité de commande selon l'une des revendications 1 à 3, dans laquelle la carte de circuits de bus de fond de panier (21) est disposée à plat ou sur l'embase, de façon à être orientée parallèlement à un rail oméga sur lequel le module principal (1) est posé.

5. Unité de commande selon l'une des revendications 1 à 4, dans laquelle la carte de circuits principale (23) et la carte de circuits de bus de fond de panier (21) sont fixées sur le radiateur (50).

6. Unité de commande selon les revendications 4 et 5, dans laquelle le radiateur (50) comporte au moins un pied de montage (57) qui dépasse jusque dans l'embase (10) et y est fixé.

7. Unité de commande selon la revendication 6, dans laquelle le radiateur (50), la carte de circuits principale (23) et la carte de circuits de bus de fond de panier (21) forment un groupe préassemblé qui est fixé ensemble sur l'embase (10).

8. Unité de commande selon la revendication 7, dans laquelle le groupe n'est fixé sur l'embase (10) qu'avec l'au moins un pied de montage (57).

9. Unité de commande selon l'une des revendications 1 à 8, dans laquelle le radiateur (50) comporte des ailettes de refroidissement internes (53) qui forment les canaux de refroidissement (52).

10. Unité de commande selon la revendication 9, dans laquelle les ailettes de refroidissement internes (53) sont perpendiculaires à la carte de circuits principale (23).

11. Unité de commande selon l'une des revendications 1 à 10, dans laquelle le radiateur (50) présente des ailettes de refroidissement externes (54) à côté desquelles au moins une carte de circuits supplémentaire (25) est disposée.

12. Unité de commande selon la revendication 11, dans laquelle les ailettes de refroidissement externes (54) sont parallèles à la carte de circuits principale (23).

13. Unité de commande selon la revendication 11 ou 12, dans laquelle au moins une des ailettes de refroidissement externes (54) sont plus courtes dans le sens longitudinal que d'autres parties du radiateur (50).

14. Système de commande avec une unité de commande munie d'un module principal (1) selon l'une des revendications 1 à 13, dans laquelle le module principal (1) est relié par une carte de circuits de bus de fond de panier (21) à au moins un module d'extension (2) monté en série.
